# EUROPEAN PATENT APPLICATION

(11) **EP 4 362 269 A1**
(43) Date of publication of application: **01.05.2024**
(21) Application number: 23168167.7
(22) Date of filing: 17.04.2023
(51) Int. Cl.: H02J 7/00

(54) **METHOD AND APPARATUS WITH BATTERY CONTROL**

(30) Priority: 16.09.2022 KR 20220117145
(71) Applicant: Samsung Electronics Co., Ltd., Suwon-si, Gyeonggi-do 16677 (KR)
(72) Inventor: Kim, Youngjae, Suwon-si (KR); Lee, Myeongjae, Suwon-si (KR)
(74) Representative: Grünecker Patent- und Rechtsanwälte PartG mbB

(57) **Abstract**

A method including determining a first internal short circuit resistance value of a first battery based on the sensor data, determining a first internal short circuit state of the first battery using the first internal short circuit resistance value, and performing a first control process of reducing a current of the first battery, for alleviating a current burden of the first battery, in response to the determined first internal short circuit state being a first state other than a predetermined normal state.

## Description

### BACKGROUND

### 1. Field

The following disclosure relates to a method and apparatus with battery control.

### 2. Description of Related Art

A battery short circuit not only deteriorates battery efficiency but also provides a main cause of thermal runaway of the battery and may cause a safety issue, such as battery explosion. Thus, battery safety can be effectively improved by detecting the short circuit before an increase in physical and thermal deformation of the battery due to the short circuit occurs. In general, a battery's short circuit may be detected by sensing a change in the current, voltage, capacity, or temperature of the battery or detecting a change in various parameters of an electric circuit model. In addition, a method of detecting multi-cell battery pack short circuit may use various deviation values between the various unit cells constituting the multi-cell battery.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is claimed in the independent claims. Preferred embodiments are specified in the dependent claims.

In a general aspect, here is provided a processor-implemented method including determining a first internal short circuit resistance value of a first battery based on obtained sensor data, determining a first internal short circuit state of the first battery using the first internal short circuit resistance value, and performing a first control process of reducing a current of the first battery, for alleviating a current burden of the first battery, in response to the determined first internal short circuit state being a first state other than a predetermined normal state.

The performing of the first control process may include transmitting a control signal to a first switch in a first circuit connected in parallel with the first battery to control a portion of a charging current of a charger to flow into the first circuit.

The method may include electrically isolating the first battery in response to the first internal short circuit state of the first battery being a reduced-performance state compared to the first state.

The performing of the first control process may include, in response to a second battery having a second internal short circuit state that is determined to be the predetermined normal state, charging the second battery with a first charging current of a charger by causing a second switch in a first circuit connected in parallel with the second battery to be turned off and transmitting a control signal to a first switch in a first circuit connected in parallel with the first battery to control a portion of the first charging current to flow into the first circuit connected in parallel with the first battery.

The performing of the first control process may include, in response to a charging current of the charger changing from the first charging current to a second charging current representing that a charging of the second battery is completed, charging the first battery with the second charging current by causing the first switch in the first circuit connected in parallel with the first battery to be turned off, and transmitting a control signal to the second switch in the first circuit connected in parallel with the second battery.

The performing of the first control process may include, in response to a second battery having a second internal short circuit state determined to be the predetermined normal state, controlling a first converter of the first battery and a second converter of the second battery to control a current greater than the first charging current supplied to the second battery and a current less than the first charging current to be supplied to the first battery.

The method may include controlling the first converter to transmit a portion of the first charging current to the second converter of the second battery and controlling the second converter to supply the current received from the first converter of the first battery to the second battery.

The performing of the first control process may include, in response to a charging current of the charger changing from the first charging current to a second charging current representing a charging of the second battery is completed, controlling the first converter and the second converter to control a current to not be supplied to the second battery and the second charging current is to be supplied to the first battery.

The performing of the first control process may include, in response to a second battery having a second internal short circuit state determined to be the predetermined normal state, controlling a first converter of the first battery and a second converter of the second battery to control a current greater than a required current of a load to be output from the second battery and a current less than the required current to be output from the first battery.

The controlling may include controlling the second converter to transmit a portion of the current output from the second battery to the first converter and controlling the first converter to supply a current received from the second converter to the load.

The method may include, in response to the first internal short circuit state being determined to be a second state and a second battery having a second internal short circuit state determined to be the predetermined normal state, performing a second control process of causing state information of the first battery to be within a first range.

The performing of the second control process may include determining whether the state information is within the first range, in response to the state information being within the first range, controlling the first battery to be in a bypass state of being electrically isolated from the second battery, in response to the state information being above the first range, controlling the first battery to be discharged faster than the second battery, and in response to the state information being below the first range, controlling the first battery to be charged until the state information enters the first range.

The method may include obtaining the sensor data from a sensor measuring information about the first battery, and the controlling of the first battery to be in the bypass state comprises controlling a first switch connected in series with first the battery to be turned off and a second switch connected in parallel with the first battery to be turned on.

In another general aspect, here is provided an electronic device including a first battery, a sensor configured to sense the first battery, a first circuit connected in parallel with the first battery, and a processor configured to obtain sensor data of the first battery from the sensor, determine a first internal short circuit resistance value of the first battery based on the sensor data, determine a first internal short circuit state of the first battery using the first internal short circuit resistance value, and perform a first control process of reducing a current of the first battery for alleviating a current burden of the first battery, in response to the determined first internal short circuit state of the first battery being a first state other than a predetermined normal state.

The processor may be configured to transmit a control signal to a first switch in the first circuit to control a portion of a charging current of a charger to flow into the first circuit.

The processor may be configured to electrically isolate the first battery in response to the first internal short circuit state of the first battery being a reduced performance state compared to the first state.

The electronic device may comprise a second battery. The processor may be configured to, in response to the second battery having a second internal short circuit state determined to be the predetermined normal state, charge the second battery with a first charging current of a charger by causing a second switch in a first circuit connected in parallel with the second battery to be turned off, and transmit a control signal to a third switch in a first circuit connected in parallel with the first battery to control a portion of the first charging current to flow into the first circuit connected in parallel with the first battery.

The first circuit may include a converter and the processor is configured to, in response to a second battery of the electronic device having a second internal short circuit state determined to be the predetermined normal state, control the converter and a converter of the second battery to control a current greater than a first charging current of a charger is supplied to the second battery and a current less than the first charging current is supplied to the first battery.

The first circuit may include a converter and the processor is configured to, in response to there being a second battery of the electronic device having a second internal short circuit state determined to be the predetermined normal state, control the converter and a converter of the second battery to control a current greater than a required current of a load is output from the second battery and a current less than the required current is output from the first battery.

In another general aspect, here is provided a battery pack that includes a plurality of batteries and a control apparatus electrically connected to the plurality of batteries, the control apparatus includes a sensor configured to monitor each of the plurality of batteries, a first circuit connected in parallel with each battery of the plurality of batteries, and a processor configured to obtain sensor data of each of the plurality of batteries from the sensor, determine a plurality of internal short circuit resistance values for each of the plurality of batteries based on the sensor data, determine a respective internal short circuit state of each battery of the plurality of batteries using respective internal short circuit resistance values, and perform a first control process of reducing a current of a first battery among the plurality of batteries for alleviating a current burden on the first battery through the first circuit connected in parallel with the first battery in response to a determined internal short circuit state of the first battery being a first state other than a predetermined normal state.

In a further general aspect, here is provided a computer-readable storage medium storing instructions that, when executed by a processor of an electronic device comprising a first battery, a sensor configured to sense the battery, and a first circuit connected in parallel with the first battery, cause the processor to obtain sensor data of the battery from the sensor, determine a first internal short circuit resistance value of the first battery based on the sensor data, determine a first internal short circuit state of the first battery using the first internal short circuit resistance value, and perform a first control process of reducing a current of the first battery for alleviating a current burden of the first battery, in response to the determined first internal short circuit state of the first battery being a first state other than a predetermined normal state.

The computer-readable storage medium may be a non-transitory computer-readable storage medium.

Other features and aspects will be apparent from the following detailed description, the drawings, and the claims.

### BRIEF DESCRIPTION OF THE DRAWINGS

FIG. 1A illustrates an example of a battery control apparatus and batteries according to one or more embodiments.
FIG. 1B illustrates an example of a battery pack including a battery control apparatus and batteries according to one or more embodiments.
FIG. 2 illustrates an example of a configuration of a battery control apparatus according to one or more embodiments.
FIG. 3 illustrates an example of a passive type of a first circuit of a battery control apparatus according to one or more embodiments.
FIG. 4 illustrates an example of an active type of a first circuit of a battery control apparatus according to one or more embodiments.
FIG. 5 illustrates an example of a second circuit of a battery control apparatus according to one or more embodiments.
FIG. 6 illustrates an example of a third circuit of a battery control apparatus according to one or more embodiments.
FIGS. 7-21 illustrate examples of operations of battery control apparatuses according to various embodiments.
FIG. 22 illustrates an example of a battery control apparatus and a single battery according to one or more embodiments.
FIG. 23 illustrates an example of an electronic device including a battery control apparatus according to one or more embodiments.
FIGS. 24 and 25 illustrate an example of a method of detecting an internal short circuit of a battery by a battery control apparatus according to one or more embodiments.
FIG. 26 illustrates an example of an electronic device according to one or more embodiments.
FIG. 27 illustrates an example of a method of controlling a battery according to one or more embodiments.

Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

As used herein, the term "and/or" includes any one and any combination of any two or more of the associated listed items. The phrases "at least one of A, B, and C", "at least one of A, B, or C', and the like are intended to have disjunctive meanings, and these phrases "at least one of A, B, and C", "at least one of A, B, or C', and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Due to manufacturing techniques and/or tolerances, variations of the shapes shown in the drawings may occur. Thus, the examples described herein are not limited to the specific shapes shown in the drawings, but include changes in shape that occur during manufacturing.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

Typically, there are methods of detecting a battery's internal short circuit. On the other hand, the typical methods of detecting a battery short circuit do not provide the capability of maintaining a stable state of a battery when the internal short circuit occurs in the battery.

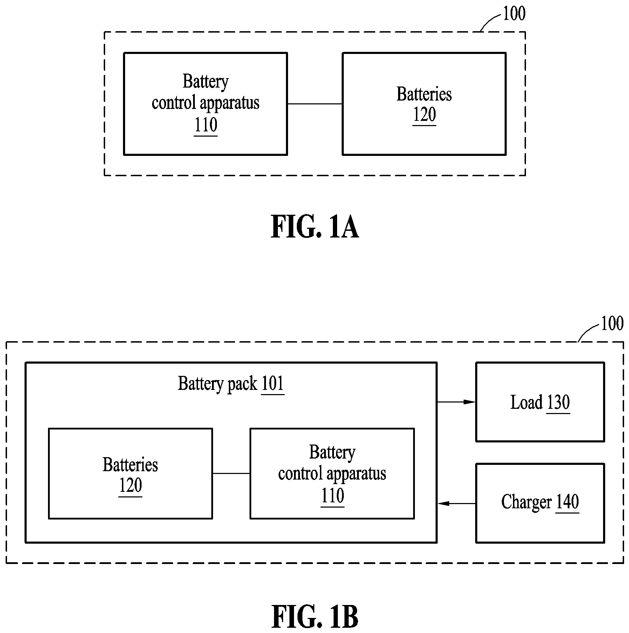

FIG. 1A illustrates an example of a battery control apparatus and batteries according to one or more embodiments.

Referring to FIG. 1A, a battery control apparatus 110 may obtain sensor data for each battery of batteries 120 using one or more sensors of an electronic device 100. The sensor is representative of, for example, any one or any combination of a voltage sensor, a current sensor, and a temperature sensor. The voltage sensor may obtain voltage data of each of the batteries 120 by sensing the voltage of each of the batteries 120. The current sensor may obtain current data of each of the batteries 120 by sensing the current of each of the batteries 120. The temperature sensor may obtain temperature data of each of the batteries 120 by sensing the temperature of each of the batteries 120.

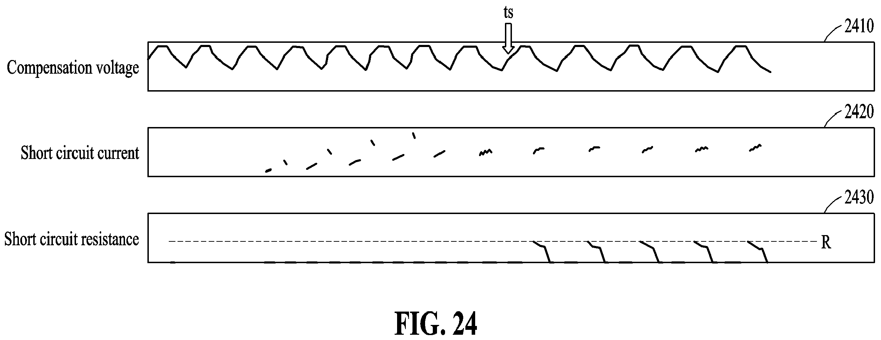

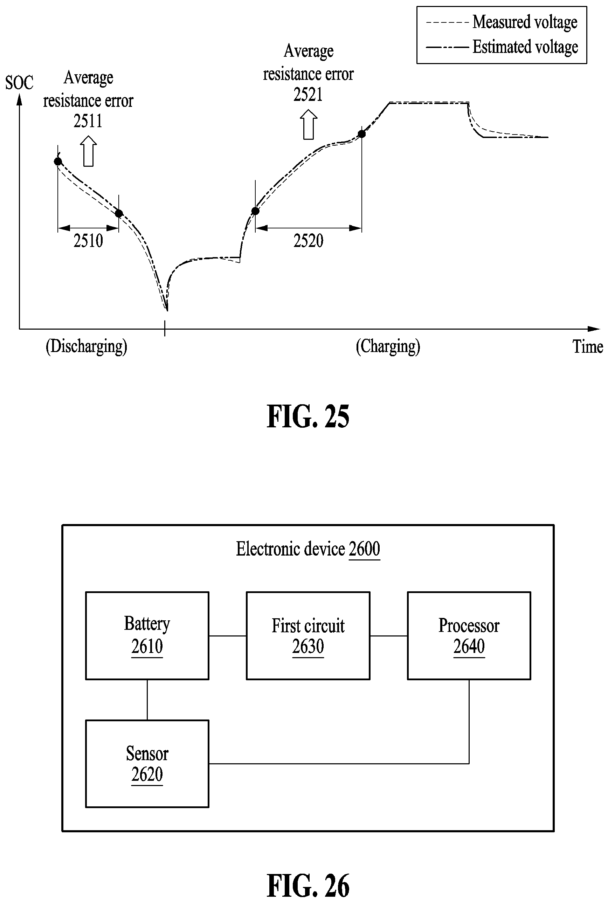

The battery control apparatus 110 may detect an internal short circuit (ISC) in each of the batteries 120 based on the sensor data (e.g., the voltage data, the current data, or the temperature data) from each of the batteries 120. The battery control apparatus 110 may calculate an estimated value of an internal short circuit current for each of the batteries 120 and determine (or calculate) a resistance value for an internal short circuit. Detecting an internal short circuit, calculating an estimated value of an internal short circuit current, and determining an internal short circuit resistance value will be described in further detail below with reference to FIGS. 24 and 25.

The battery control apparatus 110 may determine an internal state (or an internal short circuit level) of each of the batteries 120 using the estimated value of the internal short circuit current or the internal short circuit resistance value of each of the batteries 120. The internal state includes an internal short circuit state of each of the batteries 120.

For example, in response to the estimated value of the internal short circuit current of each of the batteries 120 being less than or equal to a first value (e.g., a C-rate of 1/4480), or in response to the internal short circuit resistance value being greater than or equal to a first resistance value (e.g., 6700 ohms), the battery control apparatus 110 may determine that the internal state of each of the batteries 120 is at a normal state. The normal state may be a state in which no internal short circuit (or a micro internal short) is detected.

For example, in response to an estimated value of an internal short circuit current of a first battery among the batteries 120 being between the first value (e.g., a C-rate of 1/4480) and a second value (e.g., a C-rate of 1/75), or in response to an internal short circuit resistance value of the first battery being between the first resistance value (e.g., 6700 ohms) and a second resistance value (e.g., 110 ohms), the battery control apparatus 110 may determine that the state the first battery indicates that a condition of the battery to be in an initial short circuit state (or a first state). The initial short circuit state may be a state in which an internal short circuit is detected and the resulting risk from the internal short circuit is low.

For example, in response to the estimated value of the internal short circuit current of the first battery among the batteries 120 being between the second value (e.g., a C-rate of 1/75) and a third value (e.g., a C-rate of 1/3.7), or in response to the internal short circuit resistance value of the first battery being between the second resistance value (e.g., 110 ohms) and the third resistance value (e.g., 5.5 ohms), the battery control apparatus 110 may determine that the internal state of the first battery indicates that a condition of a middle short circuit state (or a second state). The middle short circuit state may be a state in which an internal short circuit has grown compared to the initial short circuit state, and may have higher risk than the initial short circuit state.

For example, in response to the estimated value of the internal short circuit current of the first battery among the batteries 120 being greater than or equal to the third value, or in response to the internal short circuit resistance value of the first battery being less than or equal to the third resistance value, the battery control apparatus 110 may determine the internal state of the first battery indicates that a condition of the battery to be in a hard short circuit state (or a third state). The hard short circuit state may be a state in which an internal short circuit has grown compared to the middle short circuit state, and may have higher risk than the middle short circuit state.

The first value, the second value, the third value, the first resistance value, the second resistance value, and the third resistance value described above are not limited to the above examples.

The first battery in the above example may perform a self-discharge due to the internal short circuit, and the self-discharge may cause heat to occur. In response to the heat created by self-discharge and the heat caused by a repeated charge and discharge of the first battery being added together, the condition of the internal short circuit of the first battery may rapidly grow worse. An internal short circuit in the initial short circuit state may grow into an internal short circuit in the middle short circuit state, and an internal short circuit in the middle short circuit state may grow into an internal short circuit in the hard short circuit state. In response to the growth of an internal short circuit in the hard short circuit state, the internal short circuit may be in a state of high risk of thermal runaway.

The battery control apparatus 110 may perform a first control process in response to the initial short circuit state among the batteries 120, perform a second control process in response to the middle short circuit state among the batteries 120, and perform a third control process in response to the hard short circuit state among the batteries 120. The first control process, the second control process, and the third control process may be different from one another. The battery control apparatus 110 may perform a control process corresponding to a determined internal state of a respective battery.

When the first battery among the batteries 120 is determined to be the initial short circuit state, the battery control apparatus 110 may perform the first control process of reducing a current (e.g., a charging current or a discharging current) of the first battery to alleviate a current burden of the first battery. As described above, the heat caused by the repeated charge and discharge of the first battery and the heat caused by the self-discharge due to the internal short circuit may cause the severity of the internal short circuit of the first battery to grow rapidly. The battery control apparatus 110 may perform the first control process of reducing the current (e.g., the charging current or the discharging current) of the first battery, to slow the growth of the internal short circuit of the first battery in response to the internal state of the first battery being the initial short circuit state.

For example, the battery control apparatus 110 may charge the first battery with a charging current (or a charging rate) that is less than a normal charging current (or a charging rate) as in the normal state, and discharge the first battery with a discharging current (or a discharging rate) that is less than a discharging current (or a discharging rate) in the normal state. The current burden (or a power burden) of the first battery may thereby be reduced. The current burden of the battery may be reduced, such that heat corresponding to the reduced current burden may not be generated, reducing a growth rate of the internal short circuit of the first battery. The battery control apparatus 110 may prevent the first battery from being burdened with power greater than or equal to the amount of heat generated by the internal short circuit of the first battery.

In response to determining that the internal state of the first battery is the middle short circuit state, the battery control apparatus 110 may perform the second control process. In the second control process, the battery control apparatus 110 may maintain state information (e.g., a state of charge (SOC) or a capacity) of the first battery within a first range and electrically isolate the first battery from the other batteries in response to the state information of the first battery being within the first range. The first range may include a SOC range (e.g., a range from a first SOC value to a second SOC value) for causing the first battery in the middle short circuit state to be in a stable state. A lower bound (e.g., the first SOC value) of the first range may be, for example, "0". However, examples are not limited thereto. An upper bound (e.g., the second SOC value) of the first range may be a value close to "0", for example, "0.05". However, examples are not limited thereto.

When the first battery is determined to be in the hard short circuit state, the battery control apparatus 110 may perform the third control process of electrically disconnecting the batteries 120 from a load and electrically disconnecting the batteries 120 from a charger. In the third control process, the battery control apparatus 110 may notify a user that a portion of the batteries 120 are in an abnormal state.

Referring to FIG. 1B, a battery pack 101 of an electronic device 100 may include the battery control apparatus 110 and the batteries 120 according to one or more embodiments.

The battery pack 101 may be, or included in, various types of electronic devices, such as an electric vehicle, a hybrid vehicle, an autonomous vehicle, an energy storage system, and a mobile terminal (e.g., a smart phone, a tablet PC, etc.).

The battery pack 101 may receive a charging current from a charger 140 (e.g., an on-board charger), and the batteries 120 may be charged with the charging current.

The battery pack 101 may supply power to a load 130 (e.g., a motor of a vehicle, an inverter, etc.).

In response to determining that the internal state of the first battery among the batteries 120 is the hard short circuit state, the battery control apparatus 110 may electrically disconnect the battery pack 101 from the load 130 and electrically disconnect the battery pack 101 from the charger 140.

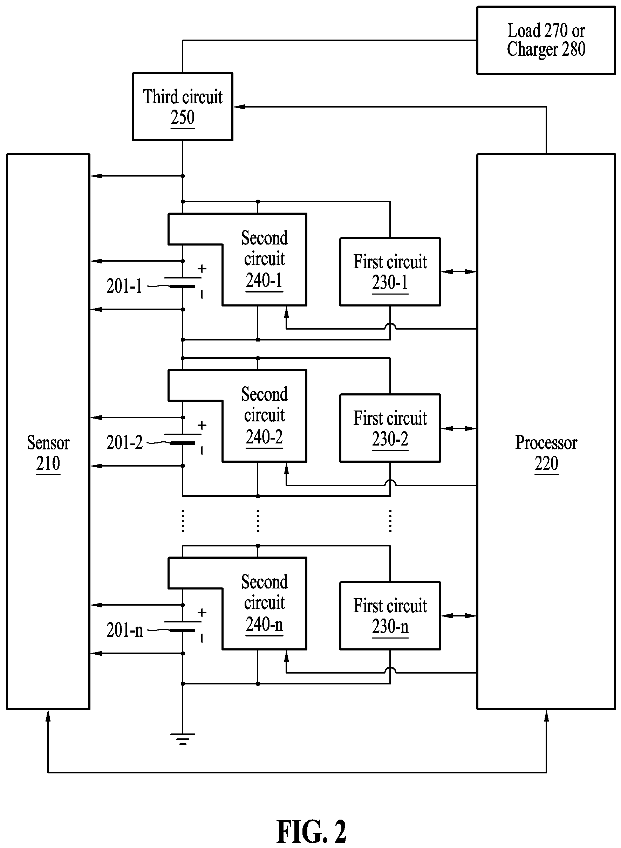

FIG. 2 illustrates an example of a configuration of a battery control apparatus according to one or more embodiments.

Referring to FIG. 2, a battery control apparatus 110 may include a sensor 210, a processor 220, a plurality of first circuits 230-1 to 230-n, a plurality of second circuits 240-1 to 240-n, and a third circuit 250.

Batteries 201-1 to 201-n (e.g., the batteries 120) may each be a battery cell or a battery module.

The batteries 201-1 to 201-n may be, for example, connected in series. However, examples are not limited thereto.

The batteries 201-1 to 201-n and the battery control apparatus 110 may be included in the battery pack 101.

The sensor 210 may obtain sensor data of each of the batteries 201-1 to 201-n. The sensor 210 may include a plurality of voltage sensors, a plurality of current sensors, and a plurality of temperature sensors. Each of the voltage sensors may obtain voltage data of a corresponding battery by sensing the voltage of the corresponding battery. Each of the current sensors may obtain current data of a corresponding battery by sensing the current of the corresponding battery. Each of the temperature sensors may obtain temperature data of a corresponding battery by sensing the temperature of the corresponding battery.

The sensor 210 may transmit the sensor data of each of the batteries 201-1 to 201-n to the processor 220. The sensor data of each of the batteries 201-1 to 201-n may include, for example, any one or any combination of the voltage data, the current data, and the temperature data of each of the batteries 201-1 to 201-n.

The sensor 210 may obtain current data of the battery pack 101 by sensing a current of the battery pack 101 (e.g., a current supplied by the battery pack 101 to a load 270 (e.g., the load 130) and/or a current flowing from a charger 280 (e.g., the charger 140) into the battery pack 101). The sensor 210 may transmit the current data of the battery pack 101 to the processor 220.

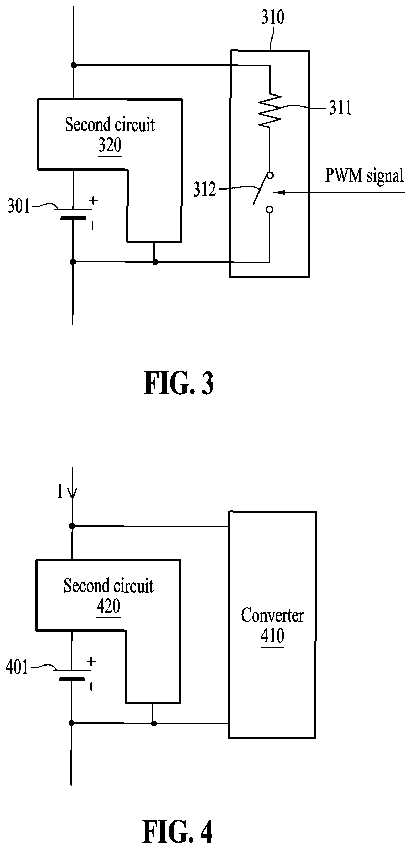

The first circuits 230-1 to 230-n may correspond to the batteries 201-1 to 201-n, respectively. Each of the first circuits 230-1 to 230-n may be connected in parallel with a corresponding battery. The first circuits 230-1 to 230-n may operate in response to an internal state of a portion of the batteries 201-1 to 201-n being determined to be an initial short circuit state and a middle short circuit state. The first circuits 230-1 to 230-n may be of a passive type or an active type. The passive type may be a type that consumes a portion of power supplied to a corresponding battery, and the active type may be a type that transmits power supplied to a corresponding battery to other first circuits. The passive type will be described in further detail below with reference to FIG. 3, and the active type will be described in further detail below with reference to FIG. 4.

Depending on an example, the processor 220 may perform balancing (e.g., passive balancing or active balancing) on the batteries 201-1 to 201-n using the first circuits 230-1 to 230-n. Accordingly, the SOCs of the batteries 201-1 to 201-n may be equalized.

The second circuits 240-1 to 240-n may correspond to the batteries 201-1 to 201-n, respectively. The second circuits 240-1 to 240-n may operate in response to an internal state of a portion of the batteries 201-1 to 201-n being determined to be a middle short circuit state. In charging or discharging the battery pack 101, each of the second circuits 240-1 to 240-n may electrically isolate a corresponding battery from the other batteries under the control of the processor 220. A state in which one of the batteries 201-1 to 201-n is electrically isolated from (or not electrically connected to) the other batteries may be referred to as a "bypass state".

The processor 220 may detect an internal short circuit of each of the batteries 201-1 to 201-n based on the sensor data of each of the batteries 201-1 to 201-n. For example, the processor 220 may calculate an estimated value of an internal short circuit current of each of the batteries 201-1 to 201-n, and determine an internal short circuit resistance value of each of the batteries 201-1 to 201-n.

The processor 220 may determine that the internal state for each of the batteries 201-1 to 201-n to is one of a normal state, an initial short circuit state, a middle short circuit state, or a hard short circuit state using the estimated value of the internal short circuit current or the internal short circuit resistance value of each of the batteries 201-1 to 201-n.

The processor 220 may determine an internal state of a portion of the batteries 201-1 to 201-n to be the initial short circuit state and determine that the internal states of the other batteries are in the normal state. The processor 220 may control the first circuits 230-1 to 230-n so that a current less than a first charging current of the charger 280 may be supplied to a battery in the initial short circuit state and the first charging current of the charger 280 may be supplied to the other batteries. The processor 220 may control the first circuits 230-1 to 230-n such that a battery in the initial short circuit state may output a current less than a required current of the load 270 and each of the other batteries may output a current greater than the required current of the load 270.

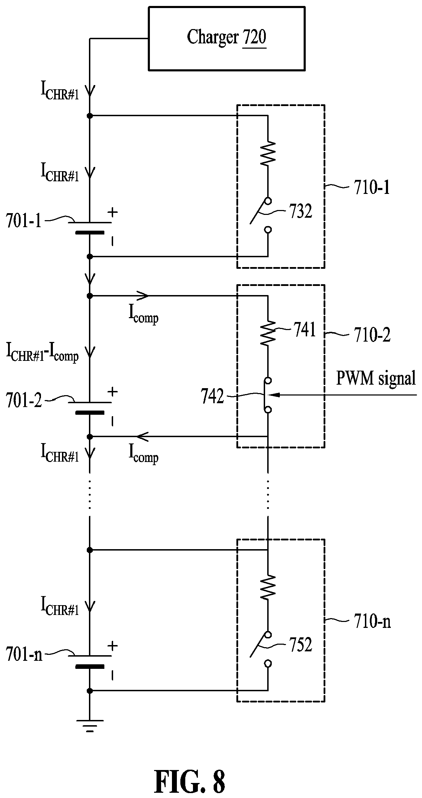

The operation of the battery control apparatus 110 in response to an internal state of a portion of batteries being determined to be an initial short circuit state will be described in further detail below with reference to FIGS. 8 and 9 and FIGS. 15A to 16.

In one scenario, the processor 220 may determine a respective internal state of one or more of the batteries 201-1 to 201-n to be the middle short circuit state while also determining that the other batteries are in the normal internal states. In this instance, the processor 220 may determine whether state information (e.g., a SOC) of the battery or batteries found to be in the middle short circuit state are within a first range.

In response to the state information (e.g., the SOC) indicating that the battery is in the middle short circuit state and within the first range, the processor 220 may control at least a portion of the first circuits 230-1 to 230-n or the second circuits 240-1 to 240-n to cause the battery in the middle short circuit state to be placed in the bypass state.

In response to the state information (e.g., the SOC) indicating that the battery is in the middle short circuit state and above the first range, the processor 220 may cause the battery to be discharged faster than the other batteries that are in the normal state. In response to the state information (e.g., the SOC) of the battery in the middle short circuit state being within the first range and being discharged, the processor 220 may place that battery into the bypass state.

If the state information (e.g., the SOC) of the battery having the middle short circuit state is within the first range, the SOC of the battery in the middle short circuit state may be decreased by a self-discharge so as to be below the first range. In other words, the SOC of the battery in the middle short circuit state may reach "0" or be less than "0". For example, even if a SOC of battery A is calculated at "0", the voltage of battery A may not be "0". If battery A is discharged in this situation, the SOC of battery A may be calculated numerically as a negative number. The SOC of the battery in the middle short circuit state may be calculated at "0" or a negative number. In this situation, the battery in the middle short circuit state may become damaged unless it is charged. In response to the SOC of the battery being in the middle short circuit state having a value below the first range (or in response to the SOC of the battery in the middle short circuit state being calculated at a value less than "0"), the processor 220 may charge that battery. In response to the state information (e.g., the SOC) of the battery having the middle short circuit state showing that the charging has placed the battery to be within the first range, the processor 220 may place that battery into the bypass state.

The processor 220 may determine that one or more of the batteries 201-1 to 201-n have an internal state within the hard short circuit state. In this case, the processor 220 may electrically disconnect the battery pack 101 from the charger 280 and electrically disconnect the battery pack 101 from the load 270 using the third circuit 250. The processor 220 may warn a user that one or more of the batteries is in an abnormal state.

FIG. 3 illustrates an example of a passive type of a first circuit of a battery control apparatus according to one or more embodiments.

In an example, each of the first circuits 230-1 to 230-n of FIG. 2 may correspond to a first circuit 310 shown in FIG. 3.

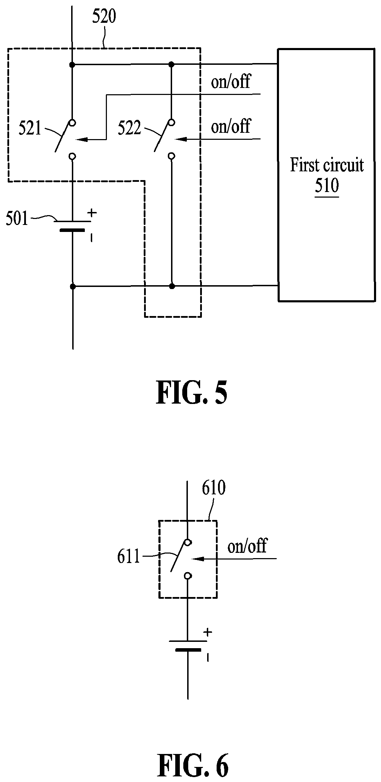

A second circuit 320 may include a plurality of switches, which will be described in further detail below with reference to FIG. 5.

The first circuit 310 may include a resistor 311 and a switch 312.

The processor 220 may control the switch 312 based on a control signal (e.g., a pulse width modulation (PWM) signal). According to the PWM signal, the switch 312 may be repeatedly turned on and off. A duty ratio of the PWM signal may be related to an intensity of a current flowing into the first circuit 310, which will be described in further detail below. The greater the duty ratio, the greater the intensity of the current flowing into the first circuit 310 may be.

In response to the switch 312 being turned on, a portion of the current supplied to the battery 301 may flow into the resistor 311, and power may be consumed by the resistor 311.

FIG. 4 illustrates an example of an active type of a first circuit of a battery control apparatus according to one or more embodiments.

In an example, each of the first circuits 230-1 to 230-n of FIG. 2 may include a converter 410 as illustrated in FIG. 4.

A second circuit 420 may include a plurality of switches, which will be described in further detail below with reference to FIG. 5.

The converter 410 may be, for example, a bidirectional direct current (DC)-to-DC converter.

The converter 410 may be connected in parallel with a battery 401.

The converter 410 may operate in a first direction to transmit a current (or power) to another converter and in a second direction to receive a current (or power) from another converter.

In the first direction, the converter 410 may transmit a portion of a current I supplied to the battery 401 to another converter.

In the second direction, the converter 410 may supply a current received from another converter to the battery 401 or to the load 270.

FIG. 5 illustrates an example of a second circuit of a battery control apparatus according to one or more embodiments.

Referring to FIG. 5, a second circuit 520 (e.g., the second circuit 320 of FIG. 3 or the second circuit 420 of FIG. 4) may include a plurality of switches 521 and 522. The switch 521 may be connected in series with a battery 501, and the switch 522 may be connected in parallel with the battery 501.

A first circuit 510 may include the first circuit 310 of FIG. 3 or the converter 410 of FIG. 4.

Each of the second circuits 240-1 to 240-n of FIG. 2 may correspond to the second circuit 520.

The processor 220 may control the switches 521 and 522. For example, the processor 220 may transmit an on signal to the switch 522 to cause the switch 522 to be turned on, and may not transmit an on signal to the switch 521 to cause the switch 521 to be turned off. In this example, the process of turning the switch 521 is described in the manner where the processor 220 does not transmit an on signal to the switch 521. In another example, the processor 220 may transmit an off signal to the switch 521 to cause the switch 521 to be turned off.

In response to the switch 522 being turned on and the switch 521 being turned off, the battery 501 may not be electrically connected to the other batteries. In other words, the battery 501 may be placed in a bypass state by the second circuit 520.

FIG. 6 illustrates an example of a third circuit of a battery control apparatus according to one or more embodiments.

Referring to FIG. 6, a third circuit 610 (e.g., the third circuit 250 of FIG. 2) may include a switch 611.

In response to an internal state of each of the batteries 201-1 to 201-n not being a hard short circuit state, the processor 220 may transmit an on signal to the switch 611 to cause the switch 611 to be turned on. In response to an internal state of a portion of the batteries 201-1 to 201-n being the hard short circuit state, the processor 220 may not transmit the on signal to the switch 611 to cause the switch 611 to be turned off. Depending on an example, the processor 220 may instead transmit an off signal to the switch 611 to cause the switch 611 to be turned off. In response to the switch 611 being turned off, the battery pack 101 may not be connected to the load 270 and the charger 280.

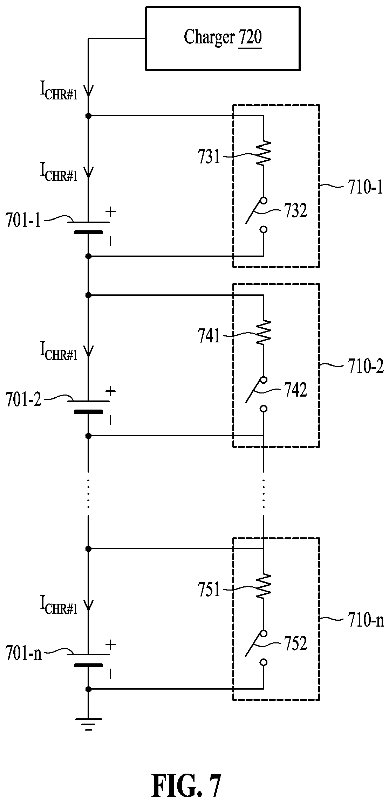

FIG. 7 illustrates an example of an operation of a battery control apparatus including a passive type of a first circuit, in response to determining internal short circuit states of batteries to be a normal state by the battery control apparatus according to one or more embodiments.

Referring to FIG. 7, first circuits 710-1 to 710-n may each be of a passive type. The first circuit 710-1 may include a resistor 731 and a switch 732. The first circuit 710-2 may include a resistor 741 and a switch 742. The first circuit 710-n may include a resistor 751 and a switch 752.

A charger 720 (e.g., the charger 140 of FIG. 1B or the charger 280 of FIG. 2) may output a first charging current I_{CHR#1}.

In the example shown in FIG. 7, the processor 220 may determine an internal state of each of batteries 701-1 to 701-n (e.g., the batteries 120 of FIGS. 1A and 1B or the batteries 201-1 to 201-n of FIG. 2) to be a normal state. In this case, the processor 220 may cause a switch included in each of the first circuits 710-1 to 710-n to be turned off.

The charger 720 may charge the batteries 701-1 to 701-n with the first charging current I_{CHR#1}.

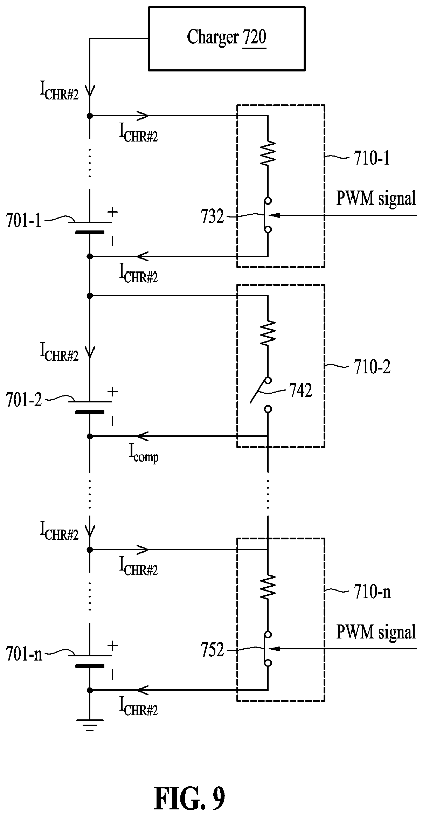

FIGS. 8 and 9 illustrate examples of an operation of a battery control apparatus including a passive type of a first circuit, in response to determining internal states of a portion of batteries to be an initial short circuit state by the battery control apparatus according to one or more embodiments.

In the example shown in FIG. 8, the processor 220 may determine the internal state of the battery 701-2 among the batteries 701-1 to 701-n to be an initial short circuit state and determine that the internal states of the remaining batteries are at a normal state.

In this example where battery 701-2 is in an initial short circuit state, the processor 220 may perform a first control process of reducing a current of the battery 701-2 to alleviate a current burden of the battery 701-2 through the first circuit 710-2 connected in parallel with the battery 701-2.

The processor 220 may determine a current value (or an intensity) of a current I_{comp} to flow into the first circuit 710-2 of the battery 701-2, of the first charging current I_{CHR#1}. For example, the processor 220 may calculate an estimated value of an internal short circuit current of the battery 701-2, and set the current value (or the intensity) of the current I_{comp} to be equal to or greater than the calculated estimated value. Accordingly, power greater than or equal to the power generated by the internal short circuit of the battery 701-2 may be consumed by the resistor 741.

The processor 220 may determine a duty ratio of a PWM signal based on the determined current value. The greater the determined current value, the greater the duty ratio of the PWM signal may be. Depending on an example, the processor 220 may use a resistance value of the resistor 741 and the determined current value to determine the duty ratio of the PWM signal.

The processor 220 may transmit the PWM signal to the switch 742 in the first circuit 710-2 of the battery 701-2. The switch 742 may be repeatedly turned off and on according to the PWM signal.

The processor 220 may cause a switch in a first circuit of each of the other batteries in the normal state to be turned off. In other words, the switch in the first circuit of each of the other batteries in the normal state may be turned off. In FIG. 8, the switch 732 and the switch 752 may be turned off.

The charger 720 may output the first charging current I_{CHR#1}.

The battery 701-1 may be charged with the first charging current I_{CHR#1}.

A portion I_{comp} of the first charging current I_{CHR#1} may flow into the first circuit 710-2, and power may be consumed by the resistor 741.

The battery 701-2 may be charged with a charging current I_{CHR#1}-I_{comp}, which is less than the first charging current I_{CHR#1}.

The battery 701-n may be charged with the first charging current I_{CHR#1}.

In the example shown in FIG. 8, the charging current I_{CHR#1}-I_{comp} of the battery 701-2 having its internal state be the initial short circuit state may be less than the first charging current I_{CHR#1}, and thus, the current burden of the battery 701-2 during charging may be alleviated. Accordingly, with the smaller charging current, a growth rate of the internal short circuit of the battery 701-2 may be slower than a growth rate where the same battery 701-2 would be charged with the first charging current I_{CHR#1}.

Since the charging current I_{CHR#1}-I_{comp} of the battery 701-2 is less than the first charging current I_{CHR#1} of each of the other batteries in the normal state, a full charge time of the battery 701-2 may be longer than a full charge time of the other batteries in the normal state. The operation of the battery control apparatus 110 in response to the other batteries in the normal state being fully charged will be described with reference to FIG. 9.

In the example shown in FIG. 9, the processor 220 may determine state information (e.g., a SOC) of each of the batteries 701-1 to 701-n based on sensor data of each of the batteries 701-1 to 701-n. The processor 220 may determine that the remaining batteries (e.g., the other batteries in the normal state) other than the battery 701-2 among the batteries 701-1 to 701-n are fully charged.

The processor 220 may transmit information indicating that the remaining batteries are fully charged to the charger 720. In response to the remaining batteries being fully charged, the charger 720 may output a second charging current I_{CHR#2} lower than the first charging current I_{CHR#1} to charge the battery 701-2. An intensity of the second charging current ICHR#2 may be the same as the intensity of the current I_{comp} of FIG. 8. However, examples are not limited thereto. The intensity of the second charging current I_{CHR#2} may be, for example, a C-rate of 0.01 or a C-rate of 0.02. However, examples are not limited thereto.

The processor 220 may transmit a PWM signal to the switch 732 in the first circuit 710-1 of the battery 701-1. The switch 732 may be repeatedly turned on and off according to the PWM signal.

The processor 220 may cause the switch 742 in the first circuit 710-2 of the battery 701-2 that is not fully charged to be turned off.

The processor 220 may transmit a PWM signal to the switch 752 in the first circuit 710-n of the battery 701-n. The switch 752 may be repeatedly turned on and off according to the PWM signal.

The switch 742 in the first circuit 710-2 may be turned off, so that the second charging current I_{CHR#2} may not flow into the first circuit 710-2 but may flow into the battery 701-2. Accordingly, the battery 701-2 may be charged with the second charging current I_{CHR#2}.

The processor 220 may determine a SOC of the battery 701-2 and determine whether the battery 701-2 is fully charged. In response to the battery 701-2 being fully charged, the processor 220 may notify the charger 720 that the battery 701-2 is fully charged, and the charger 720 may terminate charging.

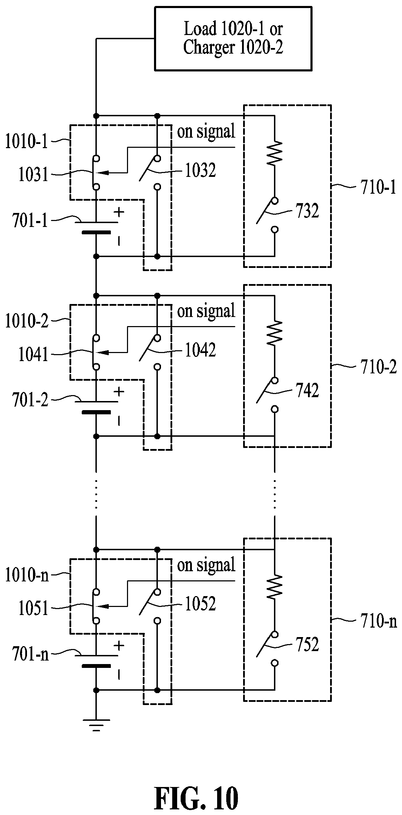

FIGS. 10 to 13 illustrate examples of an operation of a battery control apparatus including a passive type of a first circuit, in response to determining internal states of a portion of batteries to be a middle short circuit state by the battery control apparatus according to one or more embodiments.

In the examples of FIGS. 10 to 13, second circuits 1010-1 to 1010-n may each correspond to the second circuit 520 of FIG. 5.

The second circuit 1010-1 may include a switch 1031 connected in series with a corresponding battery 701-1 and a switch 1032 connected in parallel with the corresponding battery 701-1.

The second circuit 1010-2 may include a switch 1041 connected in series with a corresponding battery 701-2 and a switch 1042 connected in parallel with the corresponding battery 701-2.

The second circuit 1010-n may include a switch 1051 connected in series with a corresponding battery 701-n and a switch 1052 connected in parallel with the corresponding battery 701-n.

In the example shown in FIG. 10, the processor 220 may determine the internal state of each of the batteries 701-1 to 701-n to be a normal state.

The processor 220 may cause a switch of each of the first circuits 710-1 to 710-n to be turned off. In the example shown in FIG. 10, the switch 732, the switch 742, and the switch 752 may be turned off.

The processor 220 may cause a switch connected in series with a corresponding battery of each of the second circuits 1010-1 to 1010-n to be turned on, and cause a switch connected in parallel with a corresponding battery of each of the second circuits 1010-1 to 1010-n to be turned off. In the example shown in FIG. 10, the switch 1032, the switch 1042, and the switch 1052 may be turned on, and the switch 1031, the switch 1041, and the switch 1051 may be turned off.

The batteries 701-1 to 701-n may be charged with a first charging current of a charger 1020-2 (e.g., the charger 720) or supply power to a load 1020-1 (e.g., the load 270).

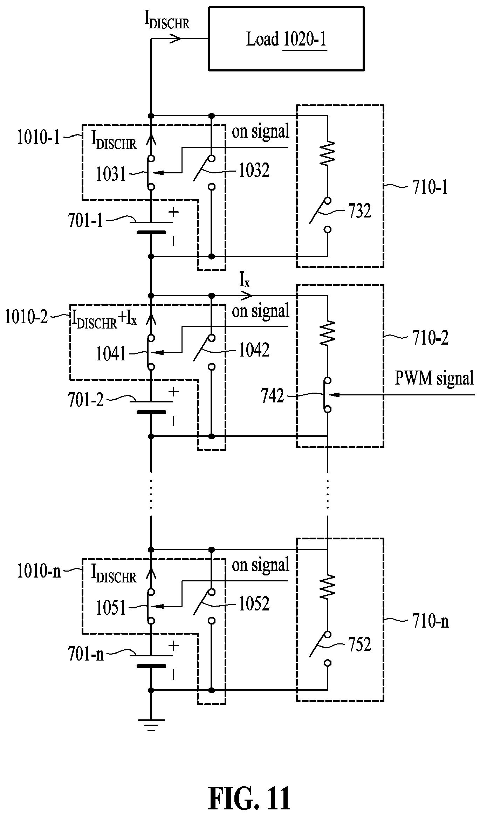

In the example shown in FIG. 11, the processor 220 may determine that the internal state of the battery 701-2 among the batteries 701-1 to 701-n is a middle short circuit state and determine that the internal states of the other batteries are a normal state. In this case, the processor 220 may maintain the SOC of the battery 701-2 within a first range, and electrically isolate the battery 701-2 from the other batteries in response to the SOC of the battery 701-2 being within the first range.

The processor 220 may cause a switch in a first circuit of each of the other, normal state batteries and a switch connected in parallel with each of the other, normal batteries to be turned off, and cause a switch connected in series with each of the other, normal batteries to be turned on. In FIG. 11, the switch 732 in the first circuit 710-1 and the switch 752 in the first circuit 710-n may be turned off, and the switch 1032 in the second circuit 1010-1 and the switch 1052 in the second circuit 1010-n may be turned off. The switch 1031 in the second circuit 1010-1 and the switch 1051 in the second circuit 1010-n may be turned on.

The processor 220 may determine whether the SOC of the battery 701-2 is within the first range. In response to the SOC of the battery 701-2 being greater than the first range, the processor 220 may control the first circuit 710-2 so that the battery 701-2 may be discharged faster than the other batteries in the normal state. For example, the processor 220 may transmit a PWM signal to the switch 742 in the first circuit 710-2 of the battery 701-2. The switch 742 may be repeatedly turned on and off according to the PWM signal. In response to the switch 742 being turned on, a portion Iₓ of an output current of the battery 701-2 may flow into the resistor 741. An intensity (or a current value) of the current Iₓ may be determined by a duty ratio of the PWM signal of the switch 742 of the resistor 741 and/or a resistance value. As a result of the current Iₓ flowing into the resistor 741, the battery 701-2 may output a current I_{DISCHR}+Iₓ, which is greater than the output current of each of the other batteries in the normal state. The battery 701-2 may be discharged faster than the other, normal batteries. In an example, the intensity of the current Iₓ may be the same as or different from the intensity of the current I_{comp} of FIG. 8.

The SOC of the battery 701-2 may decrease and thus, may enter the first range.

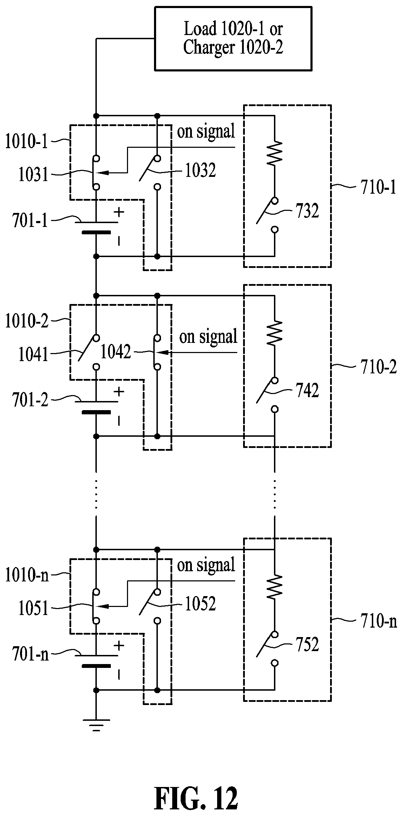

In response to the SOC of the battery 701-2 being within the first range, the processor 220 may cause the switch 1041 of the second circuit 1010-2 of the battery 701-2 to be turned off as shown in FIG. 12, and transmit an on signal to the switch 1042 of the second circuit 1010-2. The switch 1042 may be turned on according to the on signal.

In response to the switch 1041 being turned off and the switch 1042 being turned on, the battery 701-2 may be in a bypass state of being electrically isolated from the other batteries. A bypass path may be formed through the switch 1042.

In the example shown in FIG. 12, the remaining, normal batteries 701-1 and 701-n, other than the battery 701-2 that is in the middle state, may supply power to the load 1020-1 during discharging. The remaining batteries 701-1 and 701-n may be charged with a charging current (e.g., the first charging current ICHR#1 of FIG. 7) of the charger 1020-2 during charging.

The battery 701-2 in the bypass state may perform a self-discharge due to the internal short circuit. Accordingly, the SOC of the battery 701-2 may decrease and thus, may become less than the first range. In other words, the SOC of the battery 701-2 may be less than "0". The processor 220 may transmit a low power (or low C-rate) charge request to the charger 1020-2 to prevent over-discharge of the battery 701-2.

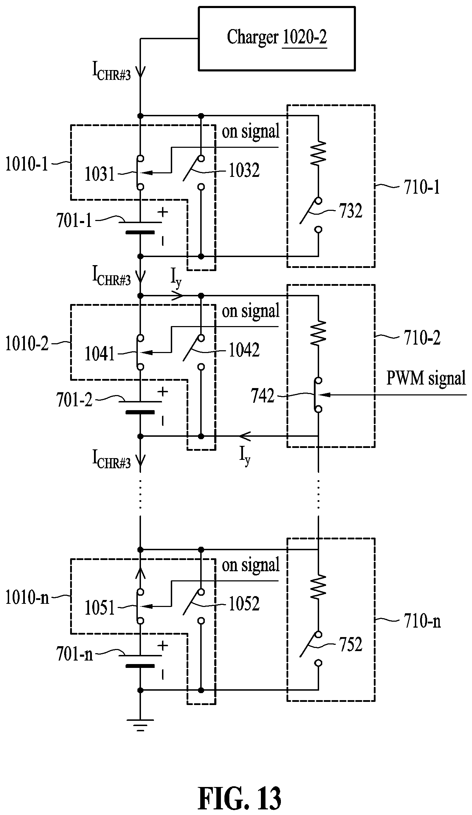

The charger 1020-2 may output a third charging current ICHR#3 as shown in the example of FIG. 13 in response to the low power charge request from the processor 220. A C-rate (or an intensity) of the third charging current ICHR#3 may be less than a C-rate (or an intensity) of the first charging current ICHR#1. Depending on an example, the C-rate (or the intensity) of the charging current ICHR#3 may be the same as or different from the C-rate (or the intensity) of the charging current ICHR#2.

In the example shown in FIG. 13, the processor 220 may transmit a PWM signal to the switch 742 in the first circuit 710-2 of the battery 701-2. The switch 742 may be repeatedly turned off and on according to the PWM signal. The processor 220 may transmit an on signal to the switch 1041 in the second circuit 1010-2 of the battery 701-2. The switch 1041 may be turned on according to the on signal. The processor 220 may cause the switch 1042 in the second circuit 1010-2 of the battery 701-2 to be turned off.

A portion I_{y} of the charging current ICHR#3 may flow into the first circuit 710-2, and the battery 701-2 may be charged with a charging current ICHR#3-Iy. Depending on an example, an intensity of the current Iy of FIG. 13 may be the same as or different from an intensity of the current Iₓ f FIG. 11.

As the battery 701-2 is charged with the charging current I_{CHR#3}-I_{y}, the SOC of the battery 701-2 may increase. As the SOC increases, the SOC of the battery 701-2 may become within the first range. In response to the SOC of the battery 701-2 being within the first range, the processor 220 may request the charger 1020-2 to stop charging. In response to the SOC of the battery 701-2 being within the first range, the processor 220 may cause the battery 701-2 to be in the bypass state as described with reference to FIG. 12.

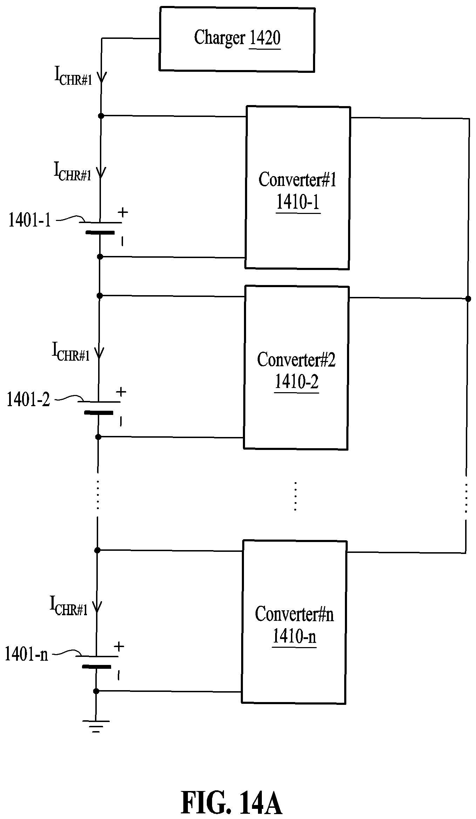

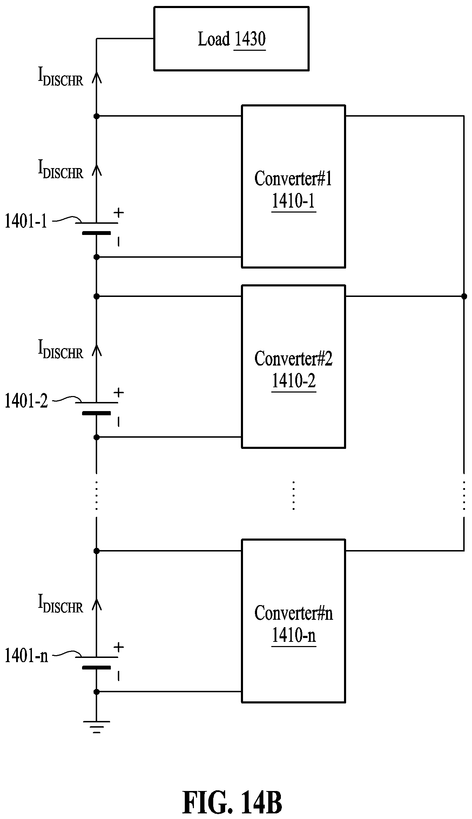

FIGS. 14A and 14B illustrate an example of an operation of a battery control apparatus including an active type of a first circuit, in response to determining internal states of batteries to be a normal state by the battery control apparatus according to one or more embodiments.

Examples of the first circuits 230-1 to 230-n of FIG. 2 each being of an active type are shown in FIGS. 14A and 14B.

In the examples shown in FIGS. 14A and 14B, converters 1410-1 to 1410-n may each correspond to the converter 410 of FIG. 4.

Each of the converters 1410-1 to 1410-n may be connected in parallel with a corresponding battery.

The converters 1410-1 to 1410-n may each be a bidirectional DC-DC converter.

Each of the converters 1410-1 to 1410-n may operate in a first direction to transmit a current (or power) to another converter and in a second direction to receive a current (or power) from another converter. The processor 220 may control each of the converters 1410-1 to 1410-n to operate in the first direction or the second direction.

The processor 220 may determine that an internal state of each of the batteries 1401-1 to 1401-n (e.g., the batteries 120 of FIG. 1A or the batteries 201-1 to 201-n of FIG. 2) is within a normal state. In this case, the processor 220 may prevent each of the converters 1410-1 to 1410-n from operating. The processor 220 may not control each of the converters 1410-1 to 1410-n. The converters 1410-1 to 1410-n may operate in neither the first direction nor the second direction.

In the example shown in FIG. 14A, a charger 1420 (e.g., the charger 140 of FIG. 1B) may output a first charging current I_{CHR#1}, and the batteries 1401-1 to 1401-n may be charged with the first charging current I_{CHR#1}.

In the example shown in FIG. 14B, in response to a required current of a load 1430 (e.g., the load 130 of FIG. 1B) being I_{DISCHR}, each of the batteries 1401-1 to 1401-n may output a current I_{DISCHR} to the load 1430.

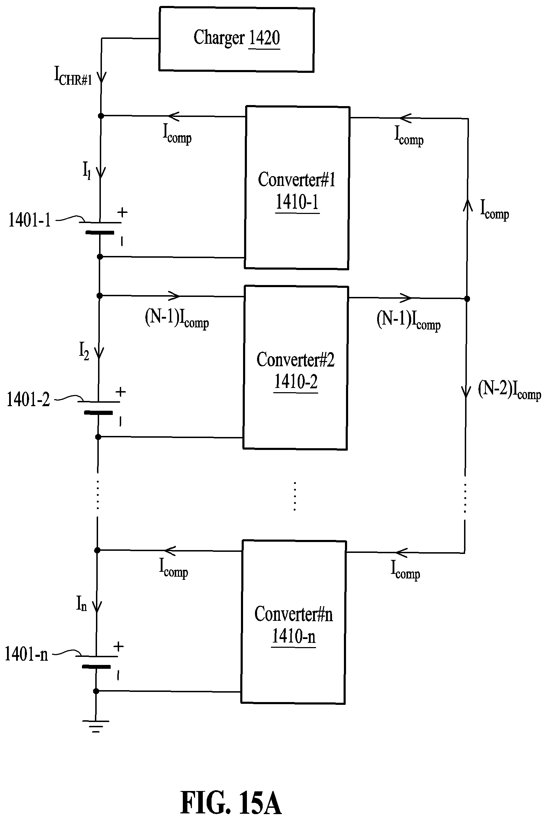

FIGS. 15A to 16 illustrate examples of an operation of a battery control apparatus including an active type of a first circuit, in response to determining internal states of a portion of the batteries to be an initial short circuit state by the battery control apparatus according to one or more embodiments.

In the example shown in FIG. 15A, the processor 220 may determine an internal state of the battery 1401-2 among the batteries 1401-1 to 1401-n to be an initial short circuit state, and determine that the internal states of the remaining batteries are within a normal state.

The processor 220 may perform a first control process of reducing a current of the battery 1401-2 to alleviate a current burden on the battery 1401-2.

The processor 220 may determine a current value (or an intensity) of the current I_{comp}, similar to the description provided with reference to FIG. 8. The processor 220 may determine a current value (N-1)×I_{comp} of a current to be transmitted to the remaining converters by the converter#2 1410-2. Here, N may denote the number of batteries 1401-1 to 1401-n.

The processor 220 may control the converters 1410-1 to 1410-n so that a current greater than the first charging current I_{CHR#1} of the charger 1420 may be supplied to the other batteries in the normal state and a current less than the first charging current I_{CHR#1} of the charger 1420 may be supplied to the battery 1401-2. The processor 220 may control the converter#2 1410-2 of the battery 1401-2 to operate in the first direction, and transmit the determined current value (N-1)×I_{comp} to the converter#2 1410-2. The processor 220 may control a converter of each of the other batteries in the normal state to operate in the second direction.

The converter#2 1410-2 of the battery 1410-2 may operate in the first direction under the control of the processor 220. The converter#2 1410-2 may equally divide the current (N-1)×I_{comp} of the first charging current I_{CHR#1} and transmit the current I_{comp} to each of the remaining converters other than the converter#2 1410-2.

The remaining converters may operate in the second direction under the control of the processor 220. Each of the remaining converters may receive the current I_{comp} from the converter#2 1410-2. The converter#1 1410-1 may receive the current I_{comp} from the converter#2 1410-2, and the converter#n 1410-n may receive the current I_{comp} from the converter#2 1410-2.

The converter#1 1410-1 may supply the current I_{comp} to the battery 1401-1.

The battery 1401-1 may be charged with a charging current I1 (e.g., I_{CHR#1}+I_{comp}), which is greater than the first charging current I_{CHR#1}.

The converter#n 1410-n may supply the current I_{comp} to the battery 1401-n.

The battery 1410-n may be charged with a charging current In (e.g., I_{CHR#1}+I_{comp}), which is greater than the first charging current I_{CHR#1}.

The battery 1401-2 may be charged with a charging current I2 (e.g., I_{CHR#1}-(N-1)×I_{comp}), which is less than the first charging current I_{CHR#1}.

In the example shown in FIG. 15A, the charging current I_{CHR#1}-(N-1)×I_{comp} of the battery 1401-2 whose internal state is determined to be an initial short circuit state may be less than the first charging current I_{CHR#1}. A current burden of the battery 1401-2 during charging may be alleviated by the lesser current. Accordingly, a growth rate of the internal short circuit of the battery 1401-2 may be slower than a growth rate in response to the battery 1401-2 being charged with the first charging current I_{CHR#1}.

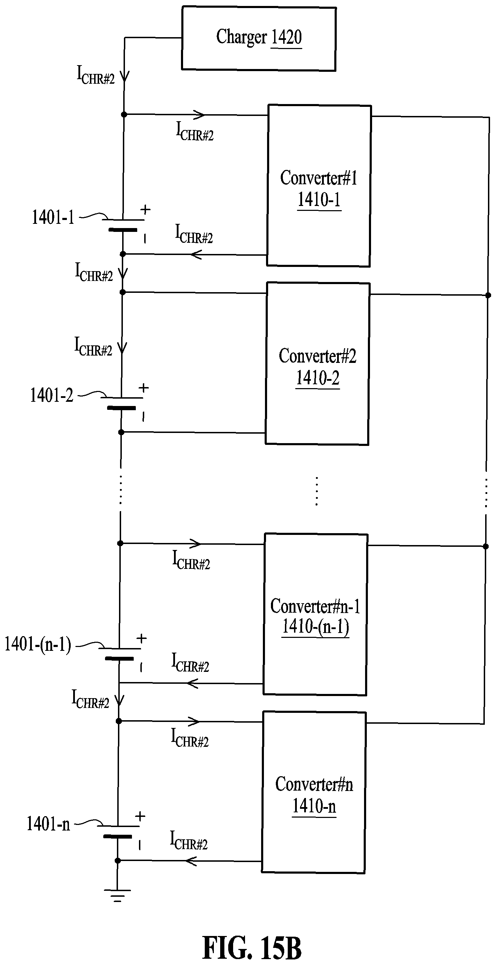

The charging current I_{CHR#1}-(N-1)×I_{comp} of the battery 1401-2 may be less than the charging current of each of the other batteries in the normal state. Thus, a full charge time of the battery 1401-2 may be longer than a full charge time of the other batteries that are in the normal state. The operation of the battery control apparatus 110 in response to the other batteries in the normal state being fully charged will be described with reference to FIG. 15B.

In the example shown in FIG. 15B, the processor 220 may determine state information (e.g., a SOC) of each of the batteries 1401-1 to 1401-n based on sensor data of each of the batteries 1401-1 to 1401-n. The processor 220 may determine that the remaining batteries other than the battery 1401-2 among the batteries 1401-1 to 1401-n are fully charged.

The processor 220 may transmit information indicating that the remaining batteries are fully charged to the charger 1420. In response to the remaining batteries being fully charged, the charger 1420 may output a second charging current I_{CHR#2} lower than the first charging current I_{CHR#1} to charge the battery 1401-2. An intensity of the charging current I_{CHR#2} may be the same as the intensity of the current I_{comp} of FIG. 15A. However, examples are not limited thereto.

In response to the other, normal batteries being fully charged, the processor 220 may control the converters 1410-1 to 1410-n so that the remaining converters, other than the converter#2 1410-2 and the battery 1401-2, may form a current path with the charger 1420. At this time, the processor 220 may prevent the converter#2 1410-2 from operating. The other batteries in the normal state and the converter#2 1410-2 may be excluded from the formed current path.

The converter#1 1410-1 may prevent the second charging current I_{CHR#2} from flowing into the corresponding battery 1401-1 under the control of the processor 220, and transmit the second charging current I_{CHR#2} to the battery 1401-2. The battery 1401-2 may be charged with the second charging current I_{CHR#2}.

Each of the converters, other than the converter#1 1410-1 and the converter#2 1410-2, may prevent the second charging current I_{CHR#2} from flowing into a corresponding battery, and cause the second charging current I_{CHR#2} to flow into the formed current path. For example, the converter#n-1 1410-(n-1) may prevent the second charging current I_{CHR#2} from flowing into a corresponding battery 1401-(n-1), and output the second charging current I_{CHR#2} to the battery 1401-n or the converter#n 1410-n. The converter#n 1410-n may prevent the second charging current I_{CHR#2} from flowing into the corresponding battery 1401-n.

In response to the battery 1401-2 being fully charged, the processor 220 may notify the charger 1420 of the full charge of the battery 1401-2. The charger 1420 may terminate the charging in response to the battery 1401-2 being fully charged.

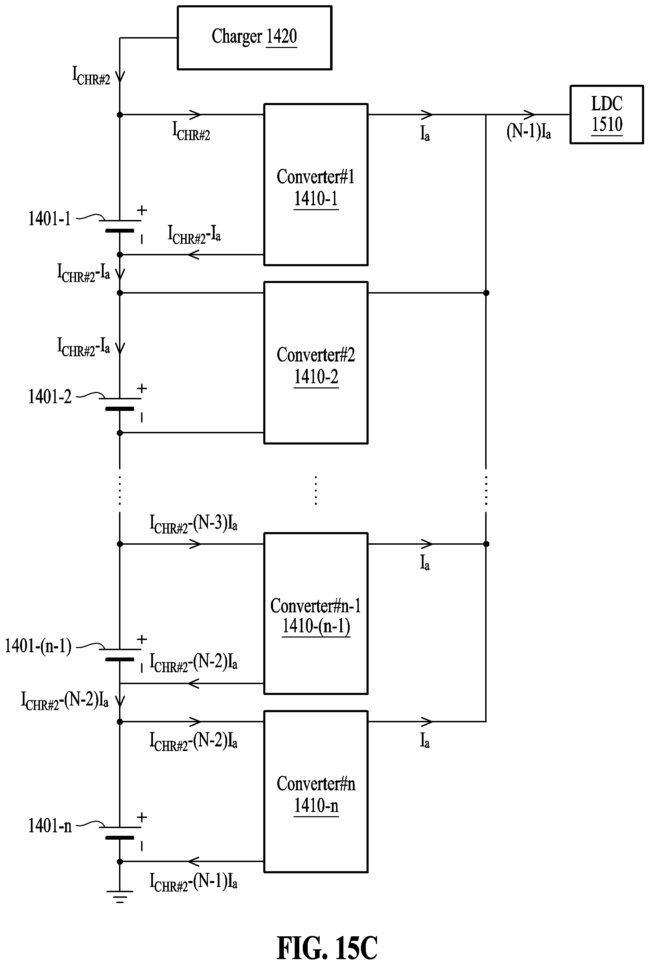

In an example, each of the remaining converters, other than the converter#2 1410-2, may supply a portion of the current input in a situation in which the current path is formed, to a low DC-to-DC converter (LDC). For example, as in the example shown in FIG. 15C, the converter#1 1410-1 may supply a portion Iₐ of the input current I_{CHR#2} to a LDC 1510, and transmit the remaining current I_{CHR#2}-Iₐ to the battery 1401-2. The converter#2 1410-2 may not operate, and thus, the battery 1401-2 may be charged with the current I_{CHR#2}-Iₐ. The converter#n-1 1410-(n-1) may supply a portion Iₐ of the input current I_{CHR#2}-(N-3)Iₐ to the LDC 1510. The converter#n-1 1410-(n-1) may prevent the remaining current I_{CHR#2}-(N-2)Iₐ from flowing into the corresponding battery 1401-(n-1), and output the current I_{CHR#2}-(N-2)Iₐ to the battery 1401-n or the converter#n 1410-n. The converter#n 1410-n may supply a portion Iₐ of the input current I_{CHR#2}-(N-2)Iₐ to the LDC 1510, and prevent the remaining current I_{CHR#2}-(N-1)Iₐ from flowing into the corresponding battery 1401-n.

The LDC 1510 may supply (N-1)Iₐ to a load (e.g., a low-voltage load).

In one example, the processor 220 may control the converters 1410-1 to 1410-n so that a current greater than the required current I_{DISCHR} of the load 1430 may be supplied by the remaining batteries other than the battery 1401-2 and a current less than the required current of the load 1430 may be supplied by the battery 1401-2. The processor 220 may control the converter#2 1410-2 of the battery 1401-2 to operate in the second direction, and control the remaining converters to operate in the first direction.

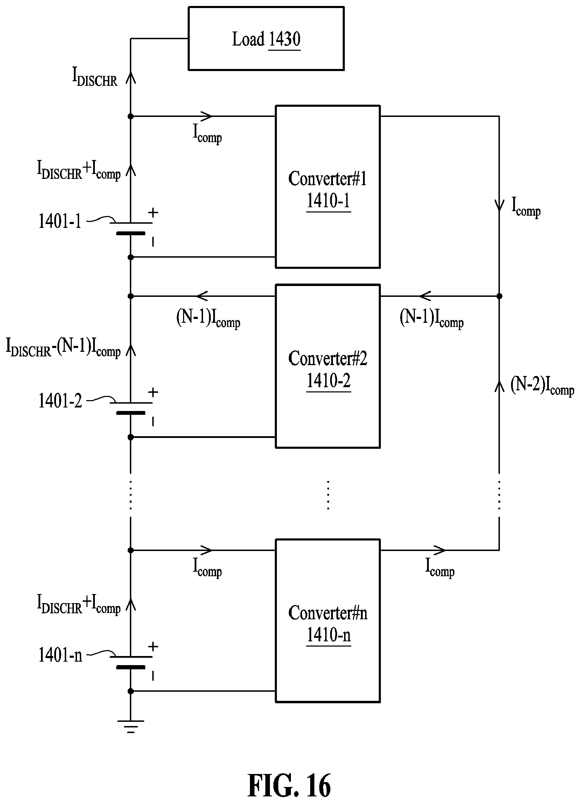

In the example shown in FIG. 16, the converter#1 1410-1 may operate in the second direction, and the battery 1401-1 may output a current I_{DISCHR}+I_{comp}, which is greater than the required current I_{DISCHR} of the load 1430. The converter#1 1410-1 may transmit a portion I_{comp} of the output current I_{DISCHR}+I_{comp} of the battery 1401-1 to the converter#2 1410-2. Similarly, the converter#n 1410-n may operate in the second direction, and the battery 1401-n may output a current I_{DISCHR}+I_{comp}, which is greater than the required current I_{DISCHR} of the load 1430. The converter#n 1410-n may transmit a portion I_{comp} of the output current I_{DISCHR}+I_{comp} of the battery 1401-n to the converter#2 1410-2.

The converter#2 1410-2 may cause the battery 1401-2 to output a current I_{DISCHR}-(N-1)×I_{comp}, which is less than the required current I_{DISCHR} of the load 1430. The converter#2 1410-2 may operate in the second direction, and receive the current I_{comp} from each of the other converters. In other words, the converter#2 1410-2 may receive the current (N-1)×I_{comp} from the other converters.

The converter#2 1410-2 may supply the current (N-1)×I_{comp} to the load 1430, and the battery 1401-2 may supply the current I_{DISCHR}-(N-1)×I_{comp} to the load 1430.

The battery 1401-2 may supply a current less than the required current I_{DISCHR} to the load 1430, which may reduce the growth rate of the internal short circuit compared to when the battery 1401-2 supplies the required current I_{DISCHR}.

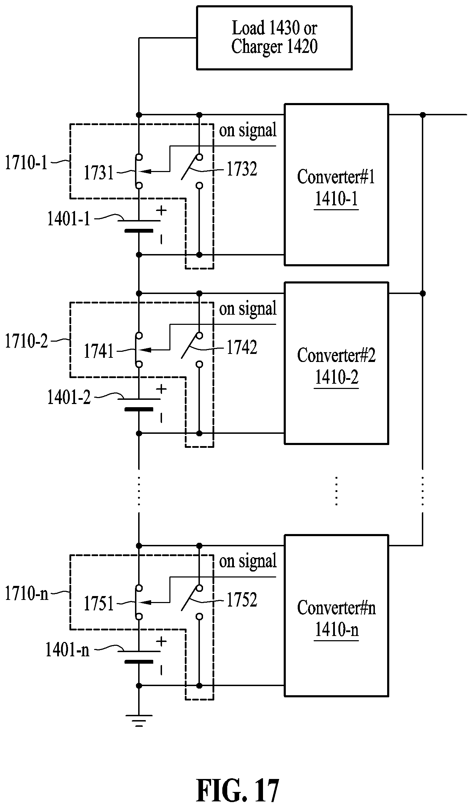

FIGS. 17 to 21 illustrate examples of an operation of a battery control apparatus including an active type of a first circuit, in response to determining internal states of a portion of batteries to be a middle short circuit state by the battery control apparatus according to one or more embodiments.

In the examples of FIGS. 17 to 21, second circuits 1710-1 to 1710-n may each correspond to the second circuit 520 of FIG. 5.

The second circuit 1710-1 may include a switch 1731 connected in series with a corresponding battery 1401-1 and a switch 1732 connected in parallel with the corresponding battery 1401-1.

The second circuit 1710-2 may include a switch 1741 connected in series with a corresponding battery 1401-2 and a switch 1742 connected in parallel with the corresponding battery 1401-2.

The second circuit 1710-n may include a switch 1751 connected in series with a corresponding battery 141-n and a switch 1752 connected in parallel with the corresponding battery 1401-n.

In the example shown in FIG. 17, the processor 220 may determine that the internal state of each of the batteries 1401-1 to 1401-n is in a normal state. In this case, the processor 220 may prevent the converters 1410-1 to 1410-n from operating. The processor 220 may cause a switch (e.g., the switch 1731, the switch 1741, the switch 1751, or the like) connected in series with a corresponding battery of each of the second circuits 1710-1 to 1710-n to be turned on, and cause a switch (e.g., the switch 1732, the switch 1742, the switch 1752, or the like) connected in parallel with a corresponding battery of each of the second circuits 1710-1 to 1710-n to be turned off.

The batteries 1401-1 to 1401-n may either be charged with a charging current (e.g., I_{CHR#1}) of the charger 1420 or supply power to the load 1430.

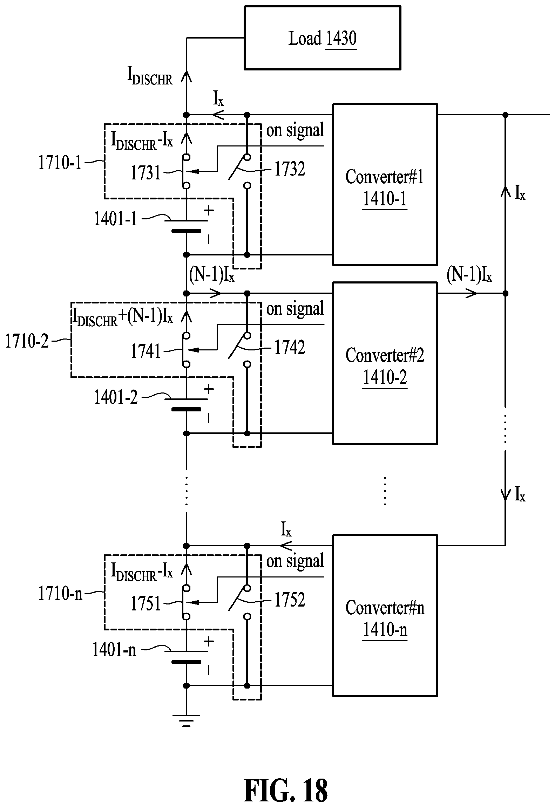

In the example shown in FIG. 18, the processor 220 may determine that the internal state of the battery 1401-2, among the batteries 1401-1 to 1401-n, to be a middle short circuit state and determine that the internal states of the remaining batteries are in a normal state. In this case, the processor 220 may maintain the SOC of the battery 1401-2 within a first range, and electrically isolate the battery 1401-2 from the other batteries in response to the SOC of the battery 1401-2 being within the first range.

The processor 220 may control a converter of each of the other batteries in the normal state to operate in the second direction. The processor 220 may cause a switch connected in parallel with each of the other batteries in the normal state to be turned off, and cause a switch connected in series with each of the other batteries in the normal state to be turned on. In FIG. 18, the converter#1 1410-1 and the converter#n 1410-n may operate in the second direction, and the switch 1732 in the second circuit 1710-1 and the switch 1752 in the second circuit 1710-n may be turned off. The switch 1731 in the second circuit 1710-1 and the switch 1751 in the second circuit 1710-n may be turned on.

The processor 220 may determine whether the SOC of the battery 1401-2 is within the first range. In response to the SOC of the battery 701-2 being greater than the first range, the processor 220 may control the converter#2 1410-2 so that the battery 1401-2 may be discharged faster than the other, normal batteries (or so that the battery 1401-2 may output greater power than the remaining batteries). The converter#2 1410-2 may operate in the first direction under the control of the processor 220.

The converter#2 1410-2 may control the battery 1401-2 to output a current I_{DISCHR}+(N-1)×Iₓ. The converter#2 1410-2 may equally divide the current (N-1)×Iₓ of the output current I_{DISCHR}+(N-1)×Iₓ of the battery 1401-2, and transmit the current Iₓ to each of the remaining converters.

Each of the remaining converters may operate in the second direction under the control of the processor 220. The converter#1 1410-1 may receive the current Iₓ from the converter#2 1410-2, and the converter#n 1410-n may receive the current Iₓ from the converter#2 1410-2.

The battery 1401-1 may output a current I_{DISCHR}-Iₓ and supply the output current to the load 1430, and the converter#1 1410-1 may supply the current Iₓ to the load 1430. The battery 1401-n may output a current I_{DISCHR}-Iₓ and supply the output current to the load 1430, and the converter#n 1410-n may supply the current Iₓ to the load 1430.

The battery 1401-2 may output a greater current I_{DISCHR}+(N-1)×Iₓ than each of the other batteries in the normal state and thus, may be discharged faster than the other batteries in the normal state.

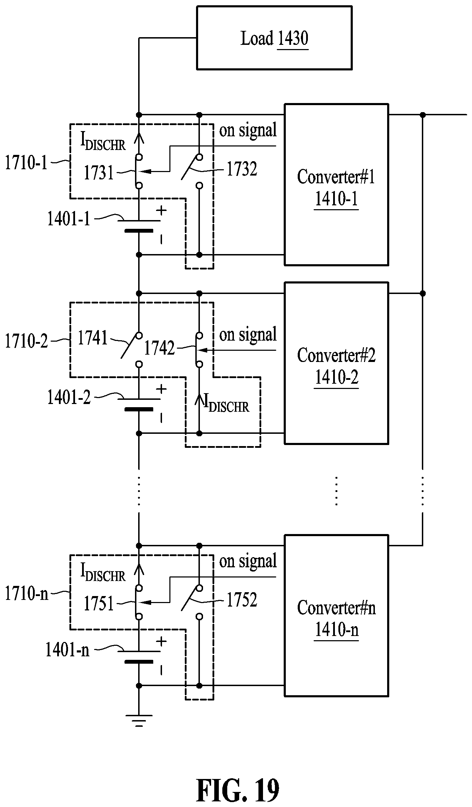

The battery 1401-2 may supply power to the load 1430, such that the SOC of the battery 1401-2 may decrease. In response to the SOC of the battery 1401-2 being within the first range, the processor 220 may prevent the converters 1410-1 to 1410-n from operating as in the example shown in FIG. 19. Accordingly, no current (or power) may be exchanged between the converter#2 1410-2 and each of the remaining converters. In response to the SOC of the battery 1401-2 being within the first range, the processor 220 may cause the switch 1741 of the second circuit 1710-2 of the battery 1401-2 to be turned off, and transmit an on signal to the switch 1742. The switch 1742 may be turned on according to the on signal.

In response to the switch 1741 being turned off and the switch 1742 being turned on, the battery 1401-2 may be in a bypass state of being electrically isolated from the other batteries in the normal state. A bypass path through the switch 1742 may be formed.

The remaining batteries other than the battery 1401-2 among the batteries 1401-1 to 1401-n may supply a current I_{DISCHR} to the load 1430.

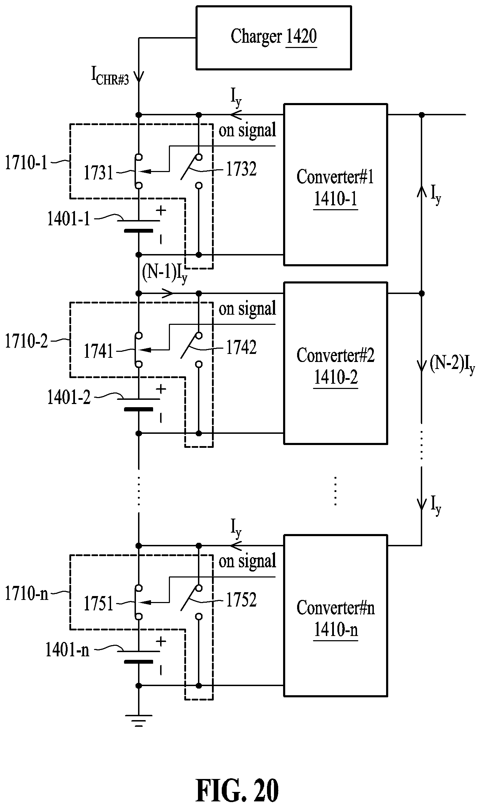

The battery 1401-2 in the bypass state may perform self-discharge due to the internal short circuit. Accordingly, the SOC of the battery 1401-2 may decrease and thus, may be under the first range. In this case, the processor 220 may transmit a low power charge request to the charger 1420 to prevent over-discharge of the battery 1401-2. A low power charging of the battery 1401-2 will be described with reference to FIG. 20.

In the example shown in FIG. 20, the processor 220 may control the converters 1410-1 to 1410-n so that a current greater than a third charging current I_{CHR#3} of the charger 1420 may be supplied to the other batteries in the normal state and a current less than the third charging current I_{CHR#3} of the charger 1420 may be supplied to the battery 1401-2. The processor 220 may control the converter 1410-2 of the battery 1401-2 to operate in the first direction, and control the remaining converters to operate in the second direction.

The processor 220 may cause the switch 1741 in the second circuit 1710-2 of the battery 1401-2 to be turned on and cause the switch 1742 to be turned off. In other words, the processor 220 may release the bypass state of the battery 1401-2.

The charger 1420 may output the third charging current I_{CHR#3} in response to the low power charge request of the processor 220. A C-rate of the third charging current I_{CHR#3} may be less than a C-rate of the charging current I_{CHR#1} of FIG. 14A.

The converter#2 1410-2 of the battery 1410-2 may operate in the first direction under the control of the processor 220. The converter#2 1410-2 may equally divide a portion (N-1)I_{y} of the third charging current I_{CHR#3} and transmit the current l_{y} to each of the remaining converters.

Each of the remaining converters may operate in the second direction under the control of the processor 220. The converter#1 1410-1 may receive the current I_{y} from the converter#2 1410-2, and the converter#n 1410-n may receive the current I_{y} from the converter#2 1410-2.

The converter#1 1410-1 may supply the currentI_{y} to the battery 1401-1. Accordingly, a current (e.g., I_{CHR#3}+I_{y}), which is greater than the third charging current I_{CHR#3}, may be supplied to the battery 1401-1.

The converter#n 1410-n may supply the current I_{y} to the battery 1401-n. Accordingly, a current (e.g., I_{CHR#3}+I_{y}), which is greater than the third charging current I_{CHR#3}, may be supplied to the battery 1401-n.

The battery 1401-2 may be charged with a current (e.g., I_{CHR#3}-(N-1)I_{y}), which is less than the third charging current I_{CHR#3}.

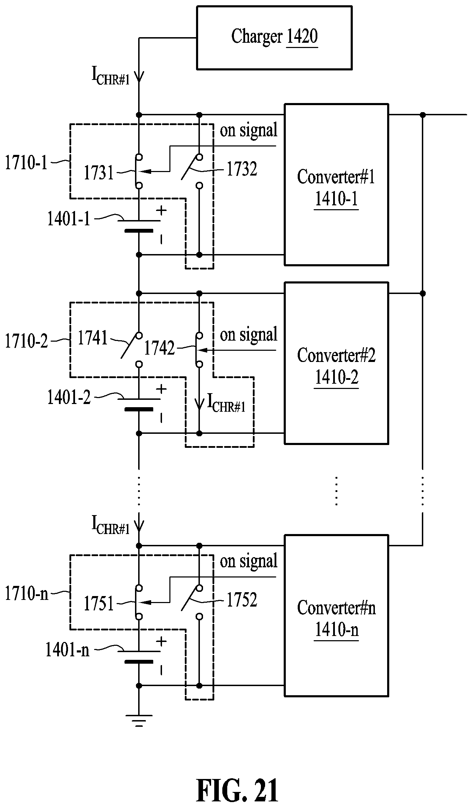

In response to the battery 1401-2 being charged, the SOC of the battery 1401-2 may be increased to be within the first range. In response to the SOC of the battery 1401-2 being within the first range, the processor 220 may request the charger 1420 to stop charging. In response to the SOC of the battery 1401-2 being within the first range, the processor 220 may prevent the converters 1410-1 to 1410-n from operating as in the example shown in FIG. 21. Accordingly, no current (or power) may be exchanged between the converter#2 1410-2 and each of the remaining converters.

In response to the SOC of the battery 1401-2 being within the first range, the processor 220 may cause the switch 1741 of the second circuit 1710-2 of the battery 1401-2 to be turned off, and transmit an on signal to the switch 1742. The switch 1742 may be turned on according to the on signal. In response to the switch 1742 being turned on, the battery 1401-2 may be in a bypass state of being electrically isolated from the other batteries. Thus, a bypass path through the switch 1742 may be formed.

In response to the battery 1401-2 being in the bypass state, the processor 220 may request the charger 1420 to change the charging current. The charger 1420 may output the first charging current I_{CHR#1}, which is greater than the third charging current I_{CHR#3}. The remaining batteries other than the battery 1401-2 among the batteries 1401-1 to 1401-n may be charged with the first charging current I_{CHR#1} of the charger 1420.

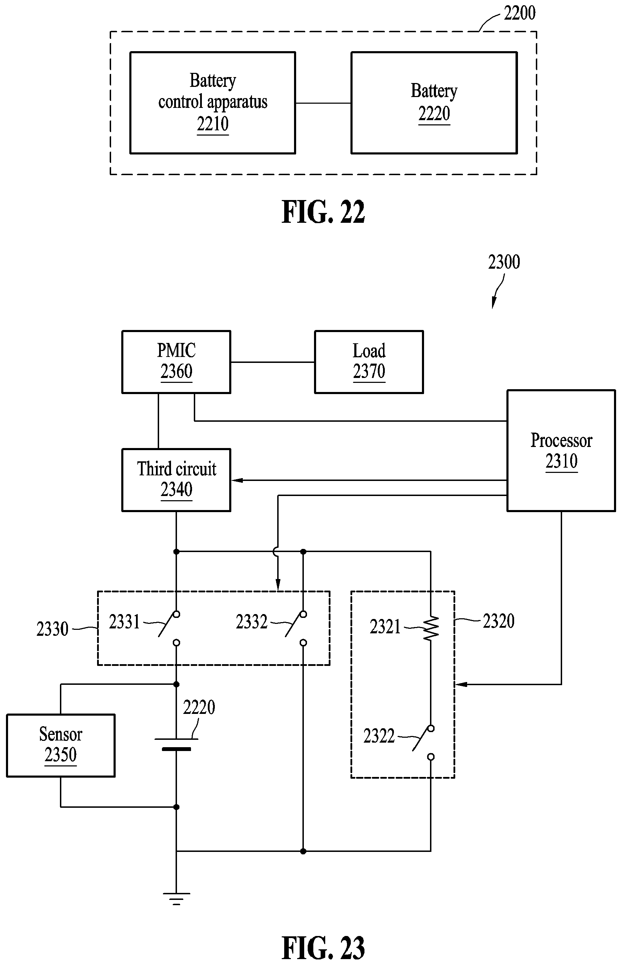

FIG. 22 illustrates an example of a battery control apparatus and a single battery according to one or more embodiments.

Referring to FIG. 22, an electronic device 2200 (e.g., the electronic device 100 of FIG. 1A or FIG.1B) includes a battery control apparatus 2210 (e.g., the battery control apparatus 110) may obtain sensor data of a battery 2220 using a sensor. The sensor data may include, for example, any one or any combination of voltage data, current data, and temperature data of the battery 2220.

The battery control apparatus 2210 may detect an internal short circuit of the battery 2220 based on the sensor data of the battery 2220. The battery control apparatus 2210 may calculate an estimated value of an internal short circuit current of the battery 2220 and determine (or calculate) an internal short circuit resistance value. This will be described in further detail below with reference to FIGS. 24 and 25.

The battery control apparatus 2210 may determine an internal state (or an internal level) (e.g., a normal state, an initial short circuit state, a middle short circuit state, or a hard short circuit state) of the battery 2220 using the estimated value of the internal short circuit current or the internal short circuit resistance value of the battery 2220.

In response to determining that the internal state of the battery 2220 is the initial short circuit state, the battery control apparatus 2210 may perform a first control process of reducing a current of the battery 2220. In response to determining that the internal state of the battery 2220 is in the middle short circuit state or in the hard short circuit state, the battery control apparatus 2210 may perform a third control process of electrically isolating the battery 2220.

The description provided with reference to FIGS. 1 to 21 may also apply to the description of FIG. 22, and thus, a detailed description will be omitted for conciseness.

FIG. 23 illustrates an example of an electronic device including a battery control apparatus and a single battery according to one or more embodiments.

Referring to FIG. 23, an electronic device 2300 may include the battery 2220, a processor 2310 (e.g., the processor 220), a first circuit 2320 (e.g., the first circuit 310 of FIG. 3), a second circuit 2330 (e.g., the second circuit 520 of FIG. 5), a third circuit 2340 (e.g., the third circuit 610 of FIG. 6), a sensor 2350, a power management integrated circuit (PMIC) 2360, and a load 2370. Depending on an example, the electronic device 2300 may not include the second circuit 2330.

The electronic device 2300 be, or a component of, a mobile device such as a smart phone, a PDA, a netbook, a tablet computer or a laptop computer, a wearable device such as a smart watch, a smart band or smart glasses, a home appliance such as a television, a smart television or a refrigerator, or a security device such as a door lock. However, the implementation may not be limited to these examples.

The load 2370 may be a component of the electronic device 2300 that uses the battery 2220 as a power source. The load 2370 (as well as other loads described herein) is representative of, for example, the processor 2310, the sensor 2350, a display, a camera, a speaker, a communication module (e.g., a mobile communication module, a Wi-Fi communication module, and/or a Bluetooth communication module, etc.), and/or a graphics processing unit (GPU), and the like. However, examples are not limited thereto.

The battery control apparatus 2210 of FIG. 22 may include the processor 2310, the first circuit 2320, the second circuit 2330, the third circuit 2340, and the sensor 2350.

The first circuit 2320 may include a resistor 2321 and a switch 2322.

The second circuit 2330 may include a switch 2331 connected in series with the battery 2220 and a switch 2332 connected in parallel with the battery 2220.

The sensor 2350 may include any one or any combination of a voltage sensor, a current sensor, and a temperature sensor.

The sensor 2350 may transmit the sensor data obtained by sensing any one or any combination of a voltage, a current, and a temperature of the battery 2220 to the processor 2310.

The processor 2310 may determine that the internal state of the battery 2220 is the initial short circuit state based on the sensor data (e.g., the voltage data, the current data, or the temperature data) of the battery 2220. The processor 2310 may transmit a PWM signal to the switch 2322 in the first circuit 2320. The switch 2322 may be repeatedly turn on and off according to the PWM signal. The processor 2310 may cause the switch 2331 to be turned on by transmitting an on signal to the switch 2331 in the second circuit 2330, and cause the switch 2332 to be turned off. The processor 2310 may transmit an on signal to a switch (e.g., the switch 611 of FIG. 6) in the third circuit 2340 to cause the switch in the third circuit 2340 to be turned on.

In response to the switch 2322 being turned on, the switch 2331 being turned on, and the switch 2332 being turned off in a situation in which the battery 2220 is being charged with a charging current of the PMIC 2360, a portion of the charging current of the PMIC 2360 may flow into the resistor 2321. A current less than the charging current of the PMIC 2360 may be supplied to the battery 2220. Accordingly, a growth rate of the internal short circuit of the battery 2220 may be decreased.

The processor 2310 may determine that the internal state of the battery 2220 is in the middle short circuit state or in the hard short circuit state based on the sensor data of the battery 2220. In this case, the processor 2310 may cause the switch in the third circuit 2340 to be turned off. Accordingly, the battery 2220 may be electrically isolated from the PMIC 2360 and the load 2370. In response to determining the internal state of the battery 2220 to be the middle short circuit state or the hard short circuit state, the processor 2310 may notify a user that the battery 2220 is in an abnormal state.

The description provided with reference to FIGS. 1 to 22 may also apply to FIG. 23 and the description of FIG. 23, and thus, a detailed description will be omitted for conciseness.

FIGS. 24 and 25 illustrate an example of a method of detecting an internal short circuit of a battery by a battery control apparatus according to one or more embodiments.

Referring to FIG. 24, graphs 2410 to 2430 may exhibit a compensation voltage, a short circuit current, and a short circuit resistance, where a time tₛ denotes a short circuit detection time. The graphs 2420 and 2430 may correspond to results of detecting a short circuit in a discharging period, and accordingly, there may be breaks (charging periods) between the curves.

The battery control apparatus 110, 2210 may determine an internal resistance value R_I of a battery (e.g., each of the batteries 120 of FIG. 1, or the battery 2220 of FIG. 22) according to an estimated voltage value V_E and a sensed current value I_M of the battery. The battery control apparatus 110, 2210 may determine an error ratio ER according to a ratio between the internal resistance value R_I and a resistance error parameter by an electrochemical model. The resistance error parameter will be described in further detail below with reference to FIG. 25. The battery control apparatus 110, 2210 may calculate an estimated value I_S of the internal short circuit current according to the product of the measured current value I_M and the error ratio ER, and determine an internal short circuit resistance value R_S according to the ratio between the estimated voltage value V_E and the estimated value I_S of the internal short circuit current.

For example, the internal resistance value R_I may be calculated by Estimated voltage value V_E/Measured current value I_M. The error ratio ER may be calculated by Resistance error parameter/Internal resistance value R_I. The internal short circuit resistance value R_S may be calculated by Estimated voltage value V_E/Short circuit current value I_S.

In the example shown in FIG. 25, the battery control apparatus 110, 2210 may set a first sub-period 2510 of a discharging period of the battery and a second sub-period 2520 of a charging period of the battery as target periods, determine an average resistance error 2511 of the first sub-period 2510 and an average resistance error 2521 of the second sub-period 2520, and determine the resistance error parameter indicating the difference between the average resistance error 2511 and the average resistance error 2521.

The method of calculating the estimated value of the internal short circuit current and the internal short circuit resistance value of the battery by the battery control apparatus 110, 2210 is not limited to the method described with reference to FIGS. 24 and 25. The battery control apparatus 110, 2210 may calculate the estimated value of the internal short circuit current and the internal short circuit resistance value of the battery through an electrochemical thermal (ECT) model, an electric circuit model, or a change in the sensor data of the battery.

FIG. 26 illustrates an example of an electronic device according to one or more embodiments.

Referring to FIG. 26, an electronic device 2600 may include a battery 2610 (e.g., at least one of the batteries 120 of FIGS. 1A and 1B, or the battery 2220), a sensor 2620 (e.g., the sensor 210 of FIG. 2 or the sensor 2350 of FIG. 23), a first circuit 2630 (e.g., the first circuit 310), and a processor 2640 (e.g., the processor 220 of FIG. 2 or the processor 2310 of FIG. 23).

The electronic device 2600 may be an electronic device as, or including, the battery pack 101 of FIG. 1B or the electronic device 2300 of FIG. 23.

The sensor 2620 may sense the battery 2610.

The first circuit 2630 may be connected in parallel with the battery 2610.

The processor 2640 may perform an operation of the processor 220 or an operation of the processor 2310.

The processor 2640 may obtain sensor data of the battery 2610 using the sensor 2620.

The processor 2640 may determine an internal short circuit resistance value of the battery 2610 based on the obtained sensor data.

The processor 2640 may determine an internal state of the battery 2610 using the determined internal short circuit resistance value.

In response to a determination that the internal state of the battery 2610 is in a first state (e.g., an initial short circuit state) other than a normal state, the processor 2640 may perform a first control process of reducing a current of the battery 2610 to alleviate a current burden of the battery 2610 through the first circuit 2630.

The processor 2640 may transmit a control signal (e.g., a PWM signal) to a switch (e.g., the switch 312) in the first circuit 2630 so that a portion of a charging current of a charger (e.g., the charger 140 or the PMIC 2360) may flow into the first circuit 2630.

In response to the internal state of the battery 2610 being a reduced performance state (e.g., a middle short circuit state or a hard short circuit state) having grown in a severity compared to the first state, the processor 2640 may electrically isolate the battery 2610.

Depending on an example, the electronic device 2600 may further include at least one battery other than the battery 2610.

The processor 2640 may determine the internal state of the battery 2610 to be the first state, and determine a short circuit state of the remaining battery to be a normal state. In other words, the electronic device 2600 may include at least one other battery whose internal state is determined to be the normal state (hereinafter, referred to as the "normal battery"). In this case, the processor 2640 may cause a switch in a first circuit connected in parallel with the normal battery to be turned off so that the normal battery may be charged with a first charging current of the charger, and transmit a control signal (e.g., a PWM signal) to a switch in a first circuit connected in parallel with the battery 2610 so that a portion of the first charging current may flow into the first circuit connected in parallel with the battery 2610. In this regard, the description provided with reference to FIGS. 8 and 9 may apply.

The first circuit 2630 may include a converter (e.g., the converter 410 of FIG. 4).

The processor 2640 may control the converter in the first circuit 2630 and a converter of the normal battery so that a current greater than the first charging current of the charger may be supplied to the normal battery and a current less than the first charging current may be supplied to the battery 2610, during charging. The processor 2640 may control the converter in the first circuit 2630 and the converter of the normal battery so that the normal battery may output a current greater than a required current of a load and the battery 2610 may output a current less than the required current, during discharging. In this regard, the description provided with reference to FIGS. 15A to 16 may apply.

The description provided with reference to FIGS. 1 to 25 may apply to the electronic device 2600 of FIG. 26.

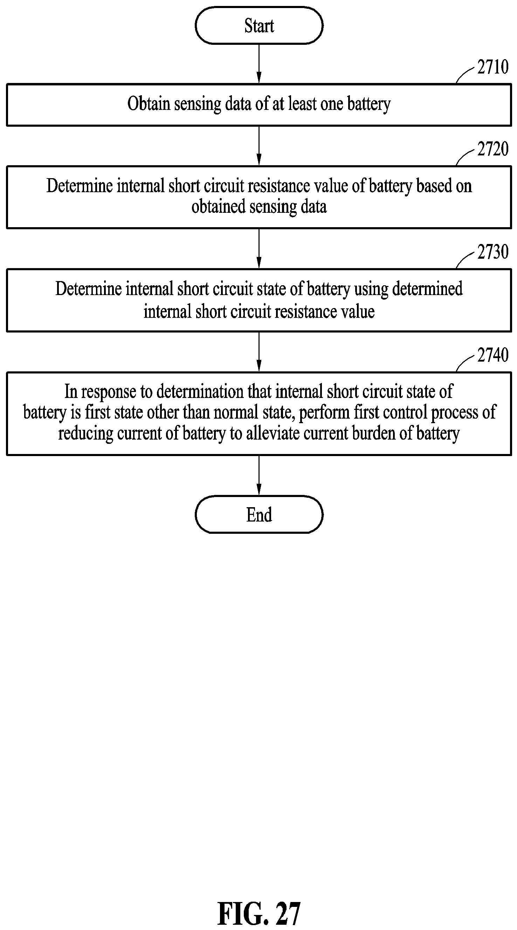

FIG. 27 illustrates an example of an operating method of a battery control apparatus according to one or more embodiments.

Referring to FIG. 27, in operation 2710, the battery control apparatus 110, 2210 may obtain sensor data of at least one battery from one or more sensors associated with that battery. For example, the sensor may be a temperature sensor, a voltage sensor, or a current sensor.

In operation 2720, the battery control apparatus 110, 2210 may determine an internal short circuit resistance value of the battery based on the obtained sensor data.

In operation 2730, the battery control apparatus 110, 2210 may determine an internal state of the battery using the determined internal short circuit resistance value.

In operation 2740, in response to the determination that the internal state of the battery is in a first state (e.g., an initial short circuit state) other than a normal state, the battery control apparatus 110, 2210 may perform a first control process of reducing a current of the battery to alleviate a current burden of the battery.

In the first control process, the battery control apparatus 110, 2210 may transmit a control signal to a switch in a first circuit connected in parallel with the battery so that a portion of a charging current of a charger may flow into the first circuit.

In response to the internal state of the battery being a reduced performance state (e.g., a middle short circuit state or a hard short circuit state) of having grown worse compared to the first state, the battery control apparatus 110, 2210 may electrically isolate the battery.

In an example, the battery control apparatus 110, 2210 may determine that the internal state of the battery (e.g., the battery 701-2) is in the first state, and in response to there being another battery whose internal state is determined to be in a normal state (e.g., a normal battery), may cause a switch in a first circuit connected in parallel with the normal battery to be turned off so that the normal battery may be charged with a first charging current of the charger. The battery control apparatus 110, 2210 may transmit a control signal to a switch (e.g., the switch 742) in a first circuit (e.g., the first circuit 710-2) connected in parallel with the battery so that a portion of the first charging current may flow into the first circuit connected in parallel with the battery in the first state. In this regard, the description of FIG. 8 may apply.

In an example, in response to the charging current of the charger changing from the first charging current to a second charging current as charging the normal battery is completed, the battery control apparatus 110, 2210 may cause the switch (e.g., the switch 742) in the first circuit

(e.g., the first circuit 710-2) connected in parallel with the battery (e.g., the battery 701-2) in the first state to be turned off, so that the battery in the first state may be charged with the second charging current. The battery control apparatus 110, 2210 may transmit the control signal to the switch in the first circuit connected in parallel with the normal battery. In this regard, the description of FIG. 9 may apply.

In an example, the battery control apparatus 110, 2210 may determine that the internal state of the battery (e.g., the battery 1401-2) is in the first state, and in response to there being another normal battery whose internal state is determined to be in the normal state, control a converter of the normal battery and a converter (e.g., the converter#2 1410-2) of the battery so that a current greater than the first charging current of the charger may be supplied to the normal battery and a current less than the first charging current may be supplied to the battery in the first state. The battery control apparatus 110, 2210 may control the converter of the battery in the first state to transmit a portion of the first charging current to the converter of the normal battery, and control the converter of the normal battery to supply the current received from the converter of the battery in the first state to the normal battery. In this regard, the description of FIG. 15A may apply.

In an example, in response to the charging current of the charger changing from the first charging current to a second charging current as the charging of the normal battery is completed, the battery control apparatus 110, 2210 may control the converter (e.g., the converter#2 1410-2) of the battery and the converter of the normal battery so that a current may not be supplied to the normal battery and the second charging current may be supplied to the battery (e.g., the battery 1401-2) in the first state. In this regard, the description of FIG. 15B may apply.

In an example, the battery control apparatus 110, 2210 may determine that the internal state of the battery (e.g., the battery 1401-2) is in the first state, and in response to there being another normal battery whose internal state is determined to be in a normal state, may control the converter (e.g., the converter#2 1410-2) of the battery in the first state and the converter of the normal battery so that the normal battery may output a current greater than a required current of a load and the battery in the first state may output a current less than the required current. The battery control apparatus 110, 2210 may control the converter of the normal battery to transmit a portion of the output current of the normal battery to the converter of the battery, and control the converter of the battery to supply the current received from the converter of the normal battery to the load. In this regard, the description of FIG. 16 may apply.

In an example, the battery control apparatus 110, 2210 may determine that the internal state of the battery tis in a second state (e.g., a middle short circuit state), and in response to there being another normal battery whose internal state is determined to be the normal state, may perform a second control process of causing state information (e.g., a SOC) of the battery in the second state to be within a first range.

In the second control process, the battery control apparatus 110, 2210 may determine whether the state information of the battery is within the first range. In response to the state information of the battery in the second state being within the first range, the battery control apparatus 110, 2210 may control the battery in the second state to be in a bypass state of being electrically isolated from the normal battery. For example, the battery control apparatus 110, 2210 may control a switch connected in series with the battery to be turned off and a switch connected in parallel with the battery to be turned on.

In response to the state information of the battery in the second state being above the first range, the battery control apparatus 110, 2210 may control the battery in the second state to be discharged faster than the normal battery. In response to the state information of the battery in the second state being below the first range, the battery control apparatus 110, 2210 may control the battery to be charged until the state information of the battery in the second state enters the first range.

The description provided with reference to FIGS. 1 to 26 may apply to the operating method of FIG. 27.

The electronic devices 100 and 2200, processors, battery control apparatus 110, 2210, processor 2640, first circuit 2630, sensor 210, a processor 220, a plurality of first circuits 230-1 to 230-n, a plurality of second circuits 240-1 to 240-n, and third circuit 250, and other circuits, switches, and processors described herein and disclosed herein described with respect to FIGS. 1-27 are implemented by or representative of hardware components. As described above, or in addition to the descriptions above, hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result.

In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-27 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. As described above, or in addition to the descriptions above, examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-rEs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the invention is defined by the enclosed claims.

## Claims

1. A processor-implemented method, the method comprising:
determining a first internal short circuit resistance value of a first battery based on obtained sensor data;
determining a first internal short circuit state of the first battery using the first internal short circuit resistance value; and
performing a first control process of reducing a current of the first battery, for alleviating a current burden of the first battery, in response to the determined first internal short circuit state being a first state other than a predetermined normal state.

2. The method of claim 1, wherein the performing of the first control process comprises transmitting a control signal to a first switch in a first circuit connected in parallel with the first battery to control a portion of a charging current of a charger to flow into the first circuit.

3. The method of claim 1 or 2, further comprising:
electrically isolating the first battery in response to the first internal short circuit state of the first battery being a reduced-performance state compared to the first state.

4. The method of claim 1, wherein the performing of the first control process comprises:
in response to a second battery having a second internal short circuit state that is determined to be the predetermined normal state, charging the second battery with a first charging current of a charger by causing a second switch in a first circuit connected in parallel with the second battery to be turned off; and
transmitting a control signal to a first switch in a first circuit connected in parallel with the first battery to control a portion of the first charging current to flow into the first circuit connected in parallel with the first battery.

5. The method of claim 4, wherein the performing of the first control process comprises, in response to a charging current of the charger changing from the first charging current to a second charging current representing that a charging of the second battery is completed, charging the first battery with the second charging current by causing the first switch in the first circuit connected in parallel with the first battery to be turned off, and transmitting a control signal to the second switch in the first circuit connected in parallel with the second battery.

6. The method of claim 5, wherein the performing of the first control process comprises, in response to a second battery having a second internal short circuit state determined to be the predetermined normal state, controlling a first converter of the first battery and a second converter of the second battery to control a current greater than the first charging current supplied to the second battery and a current less than the first charging current to be supplied to the first battery.

7. The method of claim 6, wherein the controlling comprises controlling the first converter to transmit a portion of the first charging current to the second converter of the second battery, and controlling the second converter to supply the current received from the first converter of the first battery to the second battery, or
wherein the performing of the first control process comprises, in response to a charging current of the charger changing from the first charging current to a second charging current representing a charging of the second battery is completed, controlling the first converter and the second converter to control a current to not be supplied to the second battery and the second charging current is to be supplied to the first battery.

8. The method of one of claims 1 to 7, wherein the performing of the first control process comprises, in response to a second battery having a second internal short circuit state determined to be the predetermined normal state, controlling a first converter of the first battery and a second converter of the second battery to control a current greater than a required current of a load to be output from the second battery and a current less than the required current to be output from the first battery, and
wherein the controlling comprises controlling the second converter to transmit a portion of the current output from the second battery to the first converter, and controlling the first converter to supply a current received from the second converter to the load.

9. The method of one of claims 1 to 8, further comprising, in response to the first internal short circuit state being determined to be a second state and a second battery having a second internal short circuit state determined to be the predetermined normal state, performing a second control process of causing state information of the first battery to be within a first range, wherein the performing of the second control process comprises:
determining whether the state information is within the first range;
in response to the state information being within the first range, controlling the first battery to be in a bypass state of being electrically isolated from the second battery;
in response to the state information being above the first range, controlling the first battery to be discharged faster than the second battery; and
in response to the state information being below the first range, controlling the first battery to be charged until the state information enters the first range.

10. The method of claim 9, further comprising obtaining the sensor data from a sensor measuring information about the first battery,
wherein the controlling of the first battery to be in the bypass state comprises controlling a first switch connected in series with first the battery to be turned off and a second switch connected in parallel with the first battery to be turned on.

11. A computer-readable storage medium storing instructions that, when executed by a processor of an electronic device comprising a first battery, a sensor configured to sense the battery, and a first circuit connected in parallel with the first battery, cause the processor to:
obtain sensor data of the battery from the sensor;
determine a first internal short circuit resistance value of the first battery based on the sensor data;
determine a first internal short circuit state of the first battery using the first internal short circuit resistance value; and
perform a first control process of reducing a current of the first battery for alleviating a current burden of the first battery, in response to the determined first internal short circuit state of the first battery being a first state other than a predetermined normal state.

12. The computer-readable storage medium of claim 11, wherein the processor is configured to transmit a control signal to a first switch in the first circuit to control a portion of a charging current of a charger to flow into the first circuit, or to electrically isolate the first battery in response to the first internal short circuit state of the first battery being a reduced performance state compared to the first state.

13. The computer-readable storage medium of claim 11 or 12, the electronic device further comprising a second battery, and
wherein the processor is configured to, in response to a second battery having a second internal short circuit state determined to be the predetermined normal state, charge the second battery with a first charging current of a charger by causing a second switch in a first circuit connected in parallel with the second battery to be turned off; and
transmit a control signal to a third switch in a first circuit connected in parallel with the first battery to control a portion of the first charging current to flow into the first circuit connected in parallel with the first battery.

14. The computer-readable storage medium of one of claims 11 to 13, the first circuit comprising a converter, and
wherein the processor is configured to, in response to a second battery of the electronic device having a second internal short circuit state determined to be the predetermined normal state, control the converter and a converter of the second battery to control a current greater than a first charging current of a charger is supplied to the second battery and a current less than the first charging current is supplied to the first battery, or
wherein the processor is configured to, in response to there being a second battery of the electronic device having a second internal short circuit state determined to be the predetermined normal state, control the converter and a converter of the second battery to control a current greater than a required current of a load is output from the second battery and a current less than the required current is output from the first battery.

15. A battery pack, comprising:
a plurality of batteries; and
a control apparatus electrically connected to the plurality of batteries,
wherein the control apparatus comprises:
a sensor configured to monitor each of the plurality of batteries;
a first circuit connected in parallel with each battery of the plurality of batteries; and
a processor configured to:
obtain sensor data of each of the plurality of batteries from the sensor;
determine a plurality of internal short circuit resistance values for each of the plurality of batteries based on the sensor data;
determine a respective internal short circuit state of each battery of the plurality of batteries using respective internal short circuit resistance values; and
perform a first control process of reducing a current of a first battery among the plurality of batteries for alleviating a current burden on the first battery through the first circuit connected in parallel with the first battery in response to a determined internal short circuit state of the first battery being a first state other than a predetermined normal state.
